# EUROPÄISCHE PATENTSCHRIFT

(11) **EP 3 599 649 B1**
(45) Veröffentlichungstag und Bekanntmachung des Hinweises auf die Patenterteilung: **06.10.2021**
(21) Anmeldenummer: 18186161.8
(22) Anmeldetag: 27.07.2018
(51) Int. Cl.: H01L 31/048, H01L 31/054, H01L 31/0236, H02S 20/22

(54) **SOLARMODUL MIT STRUKTURIERTER DECKPLATTE UND OPTISCHER INTERFERENZSCHICHT**
SOLAR MODULE WITH STRUCTURED COVER PLATE AND OPTICAL INTERFERENCE LAYER
MODULE SOLAIRE POURVU DE PLAQUE DE COUVERTURE STRUCTURÉE ET DE COUCHE D'INTERFÉRENCE OPTIQUE

(43) Veröffentlichungstag der Anmeldung: 29.01.2020
(73) Patentinhaber: (CNBM) Bengbu Design & Research Institute for Glass Industry Co., Ltd., 233010 Bengbu (CN)
(72) Erfinder: KALIO, René, 04357 Leipzig (DE); PALM, Jörg, 80797 München (DE); KULLMANN, Jens, 06917 Jessen (DE); DIAS, Manuel, 65183 Wiesbaden (DE); RING, Sven, 10247 Berlin (DE)
(74) Vertreter: Evans, Huw David Duncan

(56) Entgegenhaltungen:
- WO-A1-2009/062106
- WO-A1-2013/056747
- WO-A1-2015/151819
- DE-A1-102007 054 124
- US-A1- 2009 095 341

## Beschreibung

Die vorliegende Erfindung liegt auf dem technischen Gebiet der fotovoltaischen Energieerzeugung und betrifft ein Solarmodul mit einer strukturierten Deckplatte und mindestens einer optischen Interferenzschicht. Die Erfindung erstreckt sich weiterhin auf ein Verfahren zur Herstellung des erfindungsgemäßen Solarmoduls sowie dessen Verwendung.

Die Verwendung von Solarmodulen als Wand- bzw. Fassadenelemente ist derzeit ein wirtschaftlich noch relativ geringer, jedoch ökologisch sehr interessanter Markt. Insbesondere angesichts verstärkter Bemühungen für dezentrale Energielösungen und energie-neutrale Gebäude wächst der Bedarf für die Anwendung von Solarmodulen als integrierte Bestandteile von Gebäudehüllen. Weitere interessante Anwendungsbereiche für Solarmodule sind Lärmschutzwände (Straße, Schiene), Sichtschutzwände im Außenbereich oder Wände für Gewächshäuser. Diese neuen Anwendungen stellen völlig neue Anforderungen an Solarmodule, insbesondere im Hinblick auf Ästhetik, Lebensdauer und weitere Funktionalitäten wie Abdichtung und Wärmeisolation. Insbesondere müssen die hierfür eingesetzten Solarmodule in verschiedenen Formen, Größen und Farben zur Verfügung stehen und einen möglichst homogenen Farbeindruck vermitteln. Je nach Ursprung der Farbe (Absorption/Remission, Interferenz, Brechung) kann die Farbe einer an sich homogenen Oberfläche des Solarmoduls vom Betrachtungs- und/oder Einstrahlwinkel abhängen. Darüber hinaus bestimmen auch das Spektrum und die räumliche Verteilung (diffus, gerichtet) des Lichtes den Farbeindruck.

Diese neuen Anwendungen stellen völlig neue Anforderungen an Solarmodule, insbesondere im Hinblick auf Ästhetik, Lebensdauer und weitere Funktionalitäten wie Abdichtung und Wärmeisolation. Insbesondere müssen die hierfür eingesetzten Solarmodule in verschiedenen Formen, Größen und Farben zur Verfügung stehen und einen möglichst homogenen Farbeindruck vermitteln. Diese Anforderungen an die Solarmodule bereiten jedoch technische Probleme, die mit der eigentlichen Funktionalität der Solarmodule, nämlich einer möglichst effizienten Generation von elektrischer Leistung aus Sonnenlicht, in Konflikt stehen.

Ein ideales Solarmodul wäre hinsichtlich Wirkungsgradoptimierung ein schwarzer Körper, der das auftreffende Licht vollständig absorbiert, um die Strahlungsenergie optimal in elektrische Energie umzuwandeln. Jedoch wird von jedem realen Körper auftreffende Strahlung reflektiert und absorbierte Strahlung remittiert, wobei der Farbeindruck im menschlichen Auge grundsätzlich aus der spektral selektierten Reflexion und der Remission von Licht entsteht. Das Sonnenspektrum hat im sichtbaren Spektralbereich die höchste Energieintensität und das menschliche Auge die größte Empfindlichkeit. Wird ein Solarmodul farbig gestaltet, d.h. soll im menschlichen Auge ein Farbeindruck des Solarmoduls erzeugt werden, der vom idealen schwarzen Körper verschieden ist, reduziert man zwingend die Intensität des im fotovoltaisch aktiven Halbleiter absorbierten Lichts und damit auch die elektrische Leistung bzw. den Wirkungsgrad des Solarmoduls. Ein optimaler Wirkungsgrad kann grundsätzlich nur mit einem schwarzen Solarmodul erzielt werden. Andererseits kann, je nach Ursprung der Farbe (Absorption/Remission, Interferenz, Brechung), die Farbe einer an sich homogenen Oberfläche des Solarmoduls vom Betrachtungs- und/oder Einstrahlwinkel abhängen. Darüber hinaus bestimmen auch das Spektrum und die räumliche Verteilung (diffus, gerichtet) des Lichtes den Farbeindruck.

In den internationalen Patentanmeldungen WO 2015/151819 A1 und WO 2014/045142 sind Vielfach-Interferenzschichten auf der Innenseite eines Frontglases beschrieben, die einen definierten Spektralbereich des Sonnenlichts reflektieren. Derartige Vielfach-Interferenzschichten sind in der Herstellung sehr teuer und eignen sich deshalb nur bedingt für die industrielle Verwertung. Gezeigt ist auch die optionale Verwendung von diffus streuendem Deckglas, wobei sich die Vielfach-Interferenzschicht und die aufgeraute Seite des Deckglases auf verschiedenen Seiten des Deckglases befinden (VielfachInterferenzschicht innen, Aufrauung außen).

Bekannt ist auch die Verwendung von bionischen Verfahren, bei denen Nanostrukturen erzeugt werden, die denen von Schmetterlingen gleichen (siehe Fraunhofer, Bläsi et al. 33rd European PV Solar Energy Conference and Exhibition, 24-29 September 2017, Amsterdam, The Netherlands). Diese Verfahren sind sehr aufwändig und kostenintensiv und eignen sich noch nicht für die industrielle Serienfertigung von großflächigen Solarmodulen.

Bekannt ist ferner das Aufbringen von Farben auf Deckgläser im keramischen Siebdruck oder die Verwendung von organischen Glasfarben. Dies sind vergleichsweise preiswerte Technologien, die auch ein breites Spektrum von Farben erzeugen können. Zudem ist der Farbeindruck nur wenig winkelabhängig. Jedoch sind Farbschichten als solche grundsätzlich opak und lichtabsorbierend, so dass der Wirkungsgradverlust zwangsläufig sehr hoch ist. Dies gilt insbesondere für helle Farbtöne, die in aller Regel zu einem inakzeptablen Wirkungsgradverlust führen.

Demgegenüber besteht die Aufgabe der vorliegenden Erfindung darin, ein farbiges Solarmodul zur Verfügung zu stellen, wobei die Farbe möglichst wenig vom Betrachtungs- und Einstrahlwinkel abhängen soll, da ansonsten bei der Verwendung im gebäudeintegrierten Umfeld die Farbe stark vom Ort des Betrachters bzw. Sonnenstand abhängen würde. Für jede vom Kunden gewünschte Farbe sollte zudem der Wirkungsgradverlust des Solarmoduls möglichst gering sein. Für eine industrielle Serienfertigung ist es zudem wichtig, dass die Solarmodule auf großen Flächen, sowie zu akzeptablen Kosten und mit zufriedenstellender Homogenität herstellbar sind.

Diese und weitere Aufgaben werden nach dem Vorschlag der Erfindung durch ein Solarmodul und ein Verfahren zu dessen Herstellung gemäß den nebengeordneten Patentansprüchen gelöst. Vorteilhafte Ausgestaltungen der Erfindung sind durch die Merkmale der Unteransprüche angegeben.

Erfindungsgemäß ist ein Solarmodul mit elektrisch in Serie verschalteten Solarzellen zur fotovoltaischen Energieerzeugung gezeigt. Grundsätzlich kann es sich bei dem erfindungsgemäßen Solarmodul um jede Art von Solarmodul handeln, insbesondere um ein Silizium-basiertes Solarmodul auf Wafer-Basis oder ein Dünnschichtsolarmodul mit in monolithisch integrierter Form serienverschalteten Solarzellen. Vorzugsweise ist das erfindungsgemäße Solarmodul ein Dünnschichtsolarmodul. Vorteilhaft handelt es sich bei dem Solarmodul um ein Dünnschichtsolarmodul mit Verbundscheibenstruktur, welches über eine frontseitige transparente Deckplatte und ein rückseitiges Substrat (z.B. Glasplatten) verfügt, die durch eine thermoplastische oder vernetzende Polymer-Zwischenschicht (z.B. PVB oder EVA) fest miteinander verbunden sind. Die Erfindung bezieht sich insbesondere auf ein Dünnschichtsolarmodul in Substratkonfiguration, bei der der Schichtenaufbau zur Herstellung der Solarzellen auf einer der Lichteintrittsseite zugewandten Oberfläche des rückseitigen Substrats aufgebracht ist. Die Erfindung bezieht sich gleichermaßen auf ein Dünnschichtsolarmodul in Superstratkonfiguration, bei welcher der Schichtenaufbau auf einer von der Lichteintrittsseite abgewandten Oberfläche der frontseitigen transparenten Deckplatte aufgebracht ist. In Einklang mit der üblichen Verwendung bezieht sich der Begriff "Dünnschichtsolarmodul" auf Module mit einem Schichtenaufbau mit einer geringen Dicke von beispielsweise einigen Mikrometern, welche einen Träger für eine ausreichende mechanische Festigkeit benötigen. Der Träger kann beispielsweise aus anorganischem Glas, Kunststoff, Metall oder einer Metallegierung bestehen und kann in Abhängigkeit von der jeweiligen Schichtdicke und den spezifischen Materialeigenschaften als starre Platte oder biegsame Folie ausgestaltet sein.

Bei einem Dünnschichtsolarmodul umfasst der Schichtenaufbau in an sich bekannter Weise eine Rückelektrodenschicht, eine Frontelektrodenschicht, und eine zwischen Rück- und Frontelektrodenschicht angeordnete, fotovoltaisch aktive Absorberschicht. Die Frontelektrodenschicht ist optisch transparent, da ein Durchtritt von Licht zum Schichtenaufbau ermöglicht sein muss. Die optisch transparente Frontelektrodenschicht umfasst oder besteht typischer Weise aus einem dotierten Metalloxid (TCO = Transparent Conductive Oxide), beispielsweise n-leitendes, insbesondere Aluminiumdotiertes, Zinkoxid (AZO).

Vorzugsweise umfasst oder besteht die fotovoltaisch aktive Absorberschicht aus einem Chalkopyrit-Halbleiter, bei dem es sich vorteilhaft um einen ternären I-III-VI-Verbindungshalbleiter aus der Gruppe Kupfer-Indium/Gallium-Disulfid/Diselenid (Cu(In,Ga)(S,Se)₂) handelt. In vorstehender Formel können Indium und Gallium jeweils allein oder in Kombination vorliegen. Entsprechendes gilt für Schwefel und Selen, die jeweils allein oder in Kombination vorliegen können. Als Material für die Absorberschicht eignet sich in besonderer Weise CIS (Kupferindiumdiselenid/-disulfid) oder CIGS (Kupferindiumgalliumdiselenid, Kupferindiumgalliumdisulfid, Kupferindiumgalliumdisulfoselenid). Die Absorberschicht weist typischer Weise eine Dotierung von einem ersten Leitungstyp (Ladungsträgertyp) und die Frontelektrode eine Dotierung vom entgegengesetzten Leitungstyp auf. In aller Regel ist die Absorberschicht p-leitend (p-dotiert), verfügt also über einen Überschuss von Defektelektronen (Löcher) und die Frontelektrodenschicht ist n-leitend (n-dotiert), so dass freie Elektronen in Überschuss vorhanden sind. Zwischen Absorberschicht und Frontelektrodenschicht ist typischer Weise eine Pufferschicht angeordnet. Dies gilt insbesondere für Absorberschichten auf Basis von Cu(In,Ga)(S,Se)₂, bei denen in aller Regel eine Pufferschicht zwischen einer p-leitenden Cu(In,Ga)(S,Se)₂-Absorberschicht und einer n-leitenden Frontelektrode benötigt wird. Nach derzeitiger Erkenntnis ermöglicht die Pufferschicht eine elektronische Anpassung zwischen Absorber und Frontelektrode. Sie bietet außerdem einen Schutz vor Sputterschäden in einem nachfolgenden Prozeßschritt der Abscheidung der Frontelektrode beispielsweise durch DC-MagnetronSputtern. Durch die Abfolge aus n-leitender Frontelektrodenschicht, Pufferschicht und p-leitender Absorberschicht wird ein p-n-Heteroübergang gebildet, das heißt ein Übergang zwischen Schichten vom entgegengesetzten Leitungstyp. Die fotovoltaisch aktive Absorberschicht kann beispielsweise auch aus Cadmiumtellerid (CdTe) oder amorphem und/oder mikrokristallinem Silizium bestehen.

Im Dünnschichtsolarmodul sind durch Strukturierungszonen serienverschaltete Solarzellen ausgebildet. So ist mindestens die Rückelektrodenschicht durch erste Strukturierungslinien (P1-Linien) in vollständig voneinander getrennte Abschnitte unterteilt, welche die Rückelektroden der Solarzellen bilden. Ferner ist mindestens die Absorberschicht durch zweite Strukturierungslinien (P2-Linien) in vollständig voneinander getrennte Abschnitte unterteilt, welche die Absorber der Solarzellen bilden, und mindestens die Frontelektrodenschicht ist durch dritte Strukturierungslinien (P3-Linien) in vollständig voneinander getrennte Abschnitte unterteilt, welche die Frontelektroden der Solarzellen bilden. Benachbarte Solarzellen sind über elektrisch leitfähiges Material in den zweiten Strukturierungslinien in Serienverschaltung elektrisch miteinander verbunden, wobei die Frontelektrode einer Solarzelle mit der Rückelektrode der benachbarten Solarzelle elektrisch verbunden ist und mit dieser typischer Weise, jedoch nicht zwingend, direkten Berührungskontakt hat. Jede Strukturierungszone umfasst eine unmittelbare Abfolge der drei Strukturierungslinien P1-P2-P3, jeweils in dieser Reihenfolge.

In Einklang mit der gängigen Verwendung bezieht sich der Begriff "Solarzelle" auf einen Bereich des Schichtenaufbaus, der eine Frontelektrode, einen fotovoltaisch aktiven Absorber und eine Rückelektrode aufweist und von zwei einander unmittelbar benachbarten Strukturierungszonen begrenzt wird. Im Randbereich des Moduls gilt dies analog, wobei anstelle einer Strukturierungszone ein Anschlussabschnitt für eine elektrische Kontaktierung der Serienverschaltung der Solarzellen vorhanden ist, so dass die Solarzelle durch den Schichtenbereich mit Frontelektrode, Absorber und Rückelektrode definiert ist, der sich zwischen einer Strukturierungszone und dem unmittelbar angrenzenden Anschlussabschnitt befindet. Jede Solarzelle weist eine optisch aktive Zone auf, die, stapelförmig übereinander angeordnet, eine Rückelektrode, einen Absorber und eine Frontelektrode umfasst und zur fotoelektrischen Konversion von Licht in elektrischen Strom fähig ist.

Das erfindungsgemäße Solarmodul umfasst eine lichteintritts- bzw. frontseitige transparente Deckplatte, die eine der äußeren Umgebung zugewandte Außenfläche und gegenüberliegend zur Außenfläche eine Innenfläche aufweist. Die Außenfläche der Deckplatte ist im verbauten Zustand des Fassadenelements in der Fassade der äußeren Umgebung zugewandt und bildet, gegebenenfalls mit hierauf aufgebrachten Schichten, einen Teil der Außenseite bzw. Außenfläche der Fassade. Gemäß einer Ausgestaltung der Erfindung besteht die Deckplatte aus einem selben Material, beispielsweise Glas oder Kunststoff, vorzugsweise Kalknatronglas. Vorzugsweise ist die Deckplatte eine starre Glas- oder Kunststoffplatte. Die Außenfläche bzw. Innenfläche der Deckplatte wird in diesem Fall vom jeweiligen Material der Deckplatte gebildet. Gemäß einer alternativen Ausgestaltung der Erfindung besteht die Deckplatte aus mindestens zwei verschiedenen Materialien, wobei die Außenfläche und/oder Innenfläche der Deckplatte aus einem von einem Kern der Deckplatte verschiedenen Material gebildet wird. Der Kern der Deckplatte besteht vorzugsweise aus einem gleichen Material, beispielsweise Glas oder Kunststoff, vorzugsweise Kalknatronglas. Auf den Kern der Deckplatte ist außen- und/oder innenseitig ein vom Kern der Deckplatte verschiedenes Material beispielsweise in Form einer Beschichtung angebracht, welches transparent ist und einen selben optischen Brechungsindex wie das Material des Kerns der Deckplatte hat. Die Außenfläche bzw. Innenfläche der Deckplatte wird in diesem Fall vom jeweiligen Material gebildet, das auf den Kern der Deckplatte aufgebracht ist. Erfindungsgemäß umfasst der Begriff "Deckplatte" somit auch Verbundkörper, mit der Maßgabe, dass die Materialien, welche die Deckplatte formen, transparent sind und einen gleichen optischen Brechungsindex haben.

Vorzugsweise weist die Deckplatte keine Krümmung auf und ist somit plan (eben). Die Deckplatte kann jedoch auch gekrümmt sein. Ferner kann die Deckplatte starr oder biegsam sein. In Form einer biegsamen Deckplatte kann sie gleichsam in ebener Form bereitgestellt werden. Bei einer ebenen (planen) Deckplatte wird durch die Deckplatte selbst eine Ebene definiert, welche im Sinne der Erfindung als "Ebene der Deckplatte" zu verstehen ist. Bei einer gekrümmten Deckplatte kann durch eine (gedachte) ebene Tangentialfläche an einem beliebigen Punkt der Ebene eine lokale Ebene definiert werden, welche ebenfalls unter der Begriff "Ebene der Deckplatte" fällt.

Im Sinne vorliegender Erfindung bezieht sich der Begriff "Transparenz" bzw. "transparent" auf eine Durchlässigkeit für sichtbares Licht von wenigstens 85%, insbesondere wenigstens 90%, vorzugsweise wenigstens 95%, insbesondere 100%. Typischer Weise liegt sichtbares Licht im Wellenlängenbereich von 380 nm bis 780 nm vor. Der Begriff "Opazität" bzw. "opak" bezieht sich auf eine Durchlässigkeit für sichtbares Licht von weniger als 5%, insbesondere 0%. Die prozentualen Angaben beziehen sich auf die Intensität des Lichts, gemessen modulinnenseitig der frontseitigen Deckplatte, bezogen auf die Intensität des auf die frontseitige Deckplatte von der äußeren Umgebung her auftreffenden Lichts. Die Transparenz des Deckplatte kann in einfacher Weise durch eine Meßanordnung bestimmt werden, bei der beispielsweise eine Weißlichtquelle (Quelle für sichtbares Licht) auf einer Seite der frontseitigen Deckplatte und ein Detektor für sichtbares Licht auf der anderen Seite der frontseitigen Deckplatte angeordnet werden. Die nachfolgend genannten Werte für den optischen Brechungsindex beziehen sich immer auf den optischen Brechungsindex im sichtbaren Wellenlängenbereich von 380 nm bis 780 nm.

Das erfindungsgemäße Solarmodul vermittelt dem Betrachter bei Beleuchtung der Modulaußenseite mit weißem Licht, insbesondere bei Beleuchtung mit Sonnenlicht, in mindestens einem Modulabschnitt einen homogenen Farbeindruck, d.h. das Solarmodul ist im Modulabschnitt farbig. Als besonders attraktiv gelten Solarmodule mit einem homogenen Farbeindruck auf der gesamten Fläche. Die Farbe des Solarmoduls kann durch drei Farbkoordinaten L*, a*, b* beschrieben werden, wobei sich die Farbkoordinaten auf den dem Fachmann an sich bekannten (CIE)L*a*b*-Farbraum beziehen, in dem alle wahrnehmbaren Farben exakt definiert sind. Dieser Farbraum ist in der europäischen Norm EN ISO 11664-4 "Colorimetry - Part 4:CIE 1976 L*a*b* Colour space" spezifiziert, auf welche im Rahmen der vorliegenden Erfindungsbeschreibung vollumfänglich Bezug genommen wird. Im (CIE)L*a*b*-Farbraum ist jede Farbe durch einen Farbort mit den drei kartesischen Koordinaten L*, a*, b* definiert. Auf der a*-Achse liegen sich Grün und Rot gegenüber, die b*-Achse verläuft zwischen Blau und Gelb, die L*-Achse beschreibt die Helligkeit (Luminanz) der Farbe. Für eine anschaulichere Darstellung können die Größen in den Lhc-Farbraum umgerechnet werden, wobei L gleich bleibt und die Sättigung der Radius und h der Winkel eines Farbpunktes in der a*b*-Ebene ist.

Die Farbe des Solarmoduls bezieht sich auf eine Betrachtung des Solarmoduls von der äußeren Umgebung her, d.h. in Sicht auf die frontseitige Deckplatte. Die Farbmessung bzw. die Bestimmung der Farbkoordinaten des Solarmoduls kann in einfacher Weise durch ein im Handel verfügbares Farbmessgerät (Spektralphotometer) erfolgen. Das Farbmessgerät wird zu diesem Zweck auf die Außenfläche der frontseitigen Deckplatte gerichtet, insbesondere auf die Außenfläche aufgesetzt. Übliche Farbmessgeräte ermöglichen eine normgerechte Farbmessung, wobei deren Aufbau und Toleranzen typischer Weise internationalen Normen unterliegen, beispielsweise definiert durch DIN 5033, ISO/CIE 10527, ISO 7724 und ASTM E1347. Beispielsweise wird hinsichtlich der Farbmessung auf die Norm DIN 5033 vollumfänglich Bezug genommen. Ein Farbmessgerät weist als Lichtquelle beispielsweise eine Xenon-Blitzlampe, Wolfram-Halogenlampe oder ein oder mehrere LEDs auf, wobei die Außenfläche eines Körpers mit dem erzeugten (z.B. Weiß-)Licht beleuchtet und das vom Solarmodul empfangene Licht gemessen wird. Wie eingangs erläutert, ergibt sich die vom Farbmessgerät gemessene Körperfarbe aus dem reflektierten und remittierten Licht des Solarmoduls.

Um zu erreichen, dass das erfindungsgemäße Solarmodul zumindest in einem Abschnitt eine homogene Farbe mit relativ geringer Winkelabhängigkeit hat, ist auf der Innenfläche der Deckplatte eine farbgebende optische Interferenzschicht zur Reflexion von Licht innerhalb eines vorgegebenen bzw. vorgebbaren Wellenlängenbereichs angeordnet. Die optische Interferenzschicht ist vorzugsweise unmittelbar (ohne weitere Zwischenschicht) auf der Innenfläche der Deckplatte angeordnet. Zudem weist die Innenfläche und/oder die Außenfläche der Deckplatte jeweils mindestens einen strukturierten Bereich auf, mit der Maßgabe, dass entweder die Außenfläche mindestens einen strukturierten Bereich aufweist oder (d.h. alternativ) auf der Außenfläche eine weitere optische Interferenzschicht zur Reflexion von Licht innerhalb eines vorgegebenen bzw. vorgebbaren Wellenlängenbereichs angeordnet ist. Die optische Interferenzschicht ist vorzugsweise unmittelbar (ohne weitere Zwischenschicht) auf der Außenfläche der Deckplatte angeordnet. Dies bedeutet, dass keine optische Interferenzschicht auf der Außenfläche angeordnet ist, wenn die Außenfläche mindestens einen strukturierten Bereich aufweist. Wie weiter unten erläutert, ist allen erfindungsgemäßen Ausgestaltungen gemeinsam, dass das Licht mindestens einmal die Deckplatte passieren und an der innenliegenden Interferenzschicht reflektiert werden muss, um die gewünschte Farbigkeit mit der verbesserten Winkelstabilität zu erreichen.

Jede optische Interferenzschicht kann ein- oder mehrlagig ausgebildet sein, d.h. eine oder mehrere lichtbrechende Lagen (Brechungsschichten) aufweisen. Die optische Interferenzschicht dient zur Erzeugung der Farbe des Solarmoduls, wobei die optische Interferenzschicht so ausgebildet ist, dass eine konstruktive bzw. destruktive Interferenz von Licht, das an den verschiedenen Grenzflächen der optischen Interferenzschicht reflektiert wird, möglich ist. Die Farbe des Solarmoduls ergibt sich aus der Interferenz des an den Grenzflächen der optischen Interferenzschicht reflektierten Lichts. Bei Beleuchtung mit (Weiß-)Licht, insbesondere Sonnenlicht, wirkt die optische Interferenzschicht als Farbfilter zur Erzeugung einer homogenen Farbe. Die fotovoltaisch aktiven Solarzellen, welche beispielsweise schwarz-bläulich sind (CIGS-Dünnschichtsolarzellen), können zur Gesamtfarbe des Solarmoduls beitragen.

Vorzugsweise erstreckt sich der strukturierte Bereich der Außenfläche über die komplette Deckplatte, d.h. über die komplette Außenfläche der Deckplatte, so dass das Solarmodul eine homogene Farbe hat. Das Solarmodul kann auch mehrere Modulabschnitte mit jeweils homogener Farbe aufweisen. Die Farben der Modulabschnitte können gleich oder voneinander verschieden sein.

Der mindestens eine strukturierte Bereich weist senkrecht zur Ebene der Deckplatte ein Höhenprofil mit Bergen (Erhebungen) und Tälern (Einsenkungen) auf, wobei ein mittlerer Höhenunterschied zwischen den Bergen und Tälern mindestens 2 µm und vorzugsweise, jedoch nicht zwingend, maximal 20% einer Dicke der transparenten Deckplatte beträgt. Ferner setzen sich mindestens 50% des strukturierten Bereichs der Außenfläche aus unterschiedlich geneigten Segmenten bzw. Facetten zusammen. Die Segmente sind Abschnitte der zur äußeren Umgebung gerichteten Oberfläche der Deckplatte und jeweils als plane Flächen ausgebildet, die zur Ebene der Deckplatte geneigt sind. Hierbei haben, bezogen auf die Ebene der Deckplatte, mindestens 20% der Segmente einen Neigungswinkel im Bereich von größer als 0° bis maximal 15° und mindestens 30% der Segmente einen Neigungswinkel im Bereich von größer als 15° bis maximal 45°. Vorteilhaft, jedoch nicht zwingend haben weniger als 30% der Segmente einen Neigungswinkel von größer als 45°. Die Strukturen sind bevorzugt nicht periodisch und anisotrop. Für spezielle optische Effekte können jedoch auch periodische Strukturen und aniostrope Strukturen zur Anwendung kommen.

Falls die Innenfläche mindestens einen strukturierten Bereich aufweist, sind die Segmente des strukturierten Bereichs der Innenfläche jeweils eben, haben eine Segmentfläche von mindestens 1 µm² und eine mittlere Rauigkeit von weniger als 15% einer Schichtdicke der optischen Interferenzschicht auf der Innenfläche. Falls die optische Interferenzschicht aus mehreren Brechungsschichten besteht, haben die Segmente der mindestens einen Zone jeweils eine mittlere Rauigkeit von weniger als 15% einer Schichtdicke der Brechungsschicht mit geringster Schichtdicke. Die Zone, in der die Segmente jeweils eine mittlere Rauigkeit von weniger als 15% der Schichtdicke der optischen Interferenzschicht haben, kann dem strukturierten Bereich entsprechen, d.h. Zone und strukturierter Bereich sind dann identisch. Die Bedingung für die Rauigkeit der Segmente muss grundsätzlich nur erfüllt werden, falls eine optische Interferenzschicht auf einem strukturierten Bereich angeordnet ist. Dies trifft nur für den mindestens einen strukturierten Bereich der Innenfläche zu. Falls die Außenfläche mindestens einen strukturierten Bereich aufweist, gibt es keine Bedingung für die Rauigkeit der Segmente des strukturierten Bereichs, weil die Außenfläche entweder mindestens einen strukturierten Bereich aufweist oder eine optische Interferenzschicht auf der Außenfläche angeordnet ist, jedoch keine optische Interferenzschicht auf einem strukturierten Bereich der Außenfläche.

Demnach, für den Fall, dass die Innenfläche mindestens einen strukturierten Bereich aufweist, verfügt der strukturierte Bereich über eine Vielzahl von ebenen (planen) Segmenten. Im Sinne vorliegender Erfindung können ebene (plane) Segmente durch nicht-gekrümmte Flächen gebildet werden. Möglich ist aber auch, dass ebene (plane) Segmente durch geringfügig gekrümmte Flächen gebildet werden. Ein Segment ist im Sinne vorliegender Erfindung dann geringfügig gekrümmt, wenn für jeden Punkt des Segments gilt: wenn an einem Punkt des Segments eine (gedachte) Tangentialebene mit einer Fläche von 1 µm² konstruiert wird, beträgt der Abstand zwischen der Fläche des Segments und der Tangentialebene, bezogen auf die Normalenrichtung zur Tangentialebene, weniger als 50 nm.

Im Sinne vorliegender Erfindung bezeichnet der Begriff "Strukturierung" bzw. "strukturierter Bereich" einen Bereich der Außenfläche oder Innenfläche der Deckplatte, in dem die im unmittelbar vorstehenden Absatz beschriebenen Merkmale in Kombination vorliegen.

Durch die Merkmale des strukturierten Bereichs kann in vorteilhafter Weise erreicht werden, dass bei Beleuchtung der Deckplatte mit Licht auch bei einer Beobachtung außerhalb des Glanzwinkels Licht mit relativ hoher Intensität zurückgeworfen wird. Ursache hierfür sind die verschieden geneigten Segmente, die in ausreichender Anzahl, geeigneter Größe und geeigneten Neigungswinkeln vorhanden sind, um eine hohe Intensität des reflektierten Lichts auch bei einer Beobachtung außerhalb des Glanzwinkels zu ermöglichen. Es gibt stets hinreichend viele geneigte Segmente, die bei Strukturierung außen durch Brechung an den Segmenten und bei Strukturierung innen durch Reflexion an den Segmenten genügend Intensität in Richtungen außerhalb des Glanzwinkels der Deckplatte streuen.

Im Glanzwinkel gilt die Bedingung, dass der Einfallswinkel des auftreffenden Lichts dem Ausfallswinkel des reflektierten Lichts entspricht, bezogen auf die Ebene der Deckplatte. Wie hier und im Weiteren verwendet, bezieht sich der Begriff "Glanzwinkel" auf die Normale zur Ebene der Deckplatte, im Unterschied zum "lokalen Glanzwinkel", der sich auf die Normale zur Ebene eines Segments bezieht. Glanzwinkel und lokaler Glanzwinkel können gleich sein (Segment ist parallel zur Ebene der Deckplatte), sind jedoch in aller Regel verschieden (Segment ist geneigt zur Ebene der Deckplatte).

Im Ergebnis kann erreicht werden, dass die Intensität des nicht im Glanzwinkel reflektierten (d.h. gestreuten) Lichts relativ hoch ist und im Vergleich zu einer reflektierenden Oberfläche ohne einen solchen strukturierten Bereich, eine nur geringe Winkelabhängigkeit in Bezug auf die Einstrahl- und Beobachtungsrichtung hat. Mittels der optischen Interferenzschicht kann das außerhalb des Glanzwinkels reflektierte Licht, abhängig von Brechungsindex und Schichtdicke der optischen Interferenzschicht, einer Farbselektion unterzogen werden, so dass die Oberfläche der Deckplatte eine homogene Farbe mit relativ geringer Winkelabhängigkeit hat.

In dieser Hinsicht vorteilhaft weist der strukturierte Bereich ein Höhenprofil auf, bei dem ein mittlerer Höhenunterschied zwischen den Bergen und Tälern mindestens 2 µm, bevorzugt mindestens 10 µm und besonders bevorzugt mindestens 15 µm beträgt. Ein derart strukturierter Bereich kann durch Ätzen der Deckplatte (z.B. Deckglas) erzeugt werden. In dieser Hinsicht gleichermaßen vorteilhaft weist der strukturierte Bereich ein Höhenprofil auf, bei dem ein mittlerer Höhenunterschied zwischen den Bergen und Tälern mindestens 50 µm, bevorzugt mindestens 100 µm beträgt. Ein derart strukturierter Bereich kann durch Walzen der Deckplatte (z.B. Deckglas) erzeugt werden. Dementsprechend erstreckt sich die Erfindung vorteilhaft auf ein Solarmodul, dessen mindestens ein strukturierter Bereich der Deckplatte durch Ätzen oder Walzen hergestellt ist, wodurch die genannten Höhenprofile herstellbar sind. Die Strukturen können aber auch durch das Aufbringen einer transparenten und strukturierten Schicht auf die Deckplatte erzeugt werden. Die Schicht muss dabei einen gleichen (oder zumindest sehr ähnlichen) Brechungsindex haben wie die Deckplatte. Erfindungsgemäß soll das Strukturieren einer Oberfläche der Deckplatte auch das Aufbringen einer solchen transparenten und strukturierten Schicht umfassen.

Die genannten Eigenschaften des strukturierten Bereichs der Deckplatte können durch herkömmliche Messgeräte, wie ein Mikroskop, insbesondere ein Konfokalmikroskop, oder ein Nadelprofilometter, bestimmt werden.

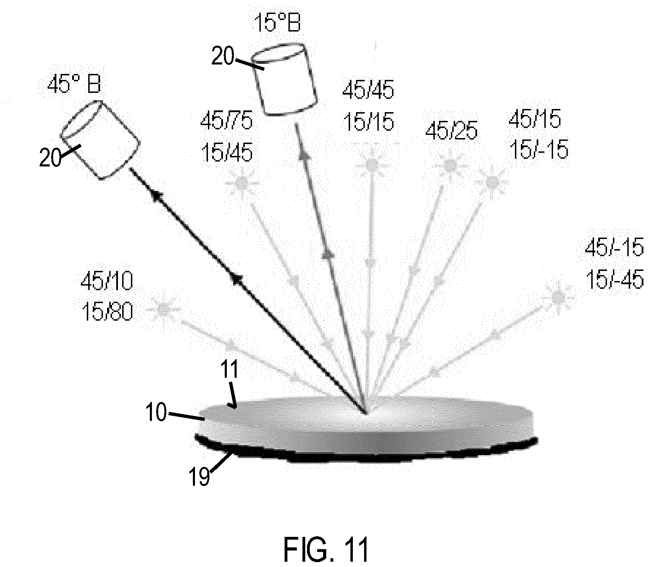

Vorzugsweise wird durch den mindestens einen strukturierten Bereich der (unbeschichteten) Deckplatte des erfindungsgemäßen Solarmoduls erreicht, dass bei Beobachtungswinkeln von 45° und 15° (jeweils bezogen auf die Normale zur Ebene der Deckplatte) und einem Einfallswinkel, der um 45° vom jeweiligen Glanzwinkel abweicht (in beiden Richtungen), eine Helligkeit L des reflektierten Lichts von mindestens 10 auftritt. Vorzugsweise tritt eine Helligkeit L des reflektierten Lichts von mindestens 15 und stärker bevorzugt mindestens 20 auf. Bei dieser Messung ist auf der von der zu charakterisierenden Seite abgewandten Seite der (unbeschichteten) Deckplatte eine schwarze Abdeckung angebracht. Für die Messung wird ein D65-Strahler verwendet und mit einem im Handel verfügbaren Mehrwinkel-Farbmessgerät die Helligkeit L gemessen (10° Öffnungswinkel). Der Messaufbau wird weiter unten in Verbindung mit Figur 11 näher erläutert. In diesem Zusammenhang wird auf die europäische Norm EN ISO 11664-4 in vollem Umfang Bezug genommen.

Die Erfindung erstreckt sich demnach auf ein Solarmodul zur fotovoltaischen Energieerzeugung, welches eine transparente Deckplatte mit einer der äußeren Umgebung zugewandten Außenfläche und einer gegenüberliegenden Innenfläche umfasst, wobei auf der Innenfläche eine optische Interferenzschicht zur Reflexion von Licht innerhalb eines vorgegebenen Wellenlängenbereichs angeordnet ist, wobei die Innenfläche und/oder die Außenfläche jeweils mindestens einen strukturierten Bereich aufweist, wobei entweder die Außenfläche mindestens einen strukturierten Bereich aufweist oder auf der Außenfläche eine weitere optische Interferenzschicht zur Reflexion von Licht innerhalb eines vorgegebenen Wellenlängenbereichs angeordnet ist, wobei der strukturierte Bereich folgende Merkmale hat:
- senkrecht zur Ebene der Deckplatte ein Berge und Täler aufweisendes Höhenprofil, wobei ein mittlerer Höhenunterschied zwischen den Bergen und Tälern mindestens 2 µm beträgt,
- mindestens 50% des strukturierten Bereichs setzt sich aus Segmenten zusammen, die zur Ebene der Deckplatte geneigt sind, wobei, bezogen auf die Ebene der Deckplatte, mindestens 20% der Segmente einen Neigungswinkel im Bereich von größer als 0° bis maximal 15° und mindestens 30% der Segmente einen Neigungswinkel im Bereich von größer als 15° bis maximal 45° haben, wobei
- falls die Innenfläche mindestens einen strukturierten Bereich aufweist, die Segmente des strukturierten Bereichs der Innenfläche jeweils eben sind, eine Segmentfläche von mindestens 1 µm² und eine mittlere Rauigkeit von weniger als 15% einer Schichtdicke der optischen Interferenzschicht auf der Innenfläche haben.

Hierbei ist es von Vorteil, wenn die mit einer schwarzen Rückfläche versehene, strukturierte, unbeschichtete Deckplatte so ausgebildet ist, dass bei einem Beobachtungswinkel von 45° und 15° (jeweils bezogen auf die Normale zur Ebene der Deckplatte) und einem Einfallswinkel, der um 45° vom jeweiligen Glanzwinkel (in beiden Richtungen) abweicht, eine Helligkeit L des reflektierten Lichts von mindestens 10, mindestens 15 oder mindestens 20 auftritt.

Die Erfindung erstreckt sich gleichermaßen auf ein Solarmodul zur fotovoltaischen Energieerzeugung, welches eine transparente Deckplatte mit einer der äußeren Umgebung zugewandten Außenfläche und einer gegenüberliegenden Innenfläche umfasst, wobei auf der Innenfläche eine optische Interferenzschicht zur Reflexion von Licht innerhalb eines vorgegebenen Wellenlängenbereichs angeordnet ist, wobei die Innenfläche und/oder die Außenfläche jeweils mindestens einen strukturierten Bereich aufweist, wobei entweder die Außenfläche mindestens einen strukturierten Bereich aufweist oder auf der Außenfläche eine weitere optische Interferenzschicht zur Reflexion von Licht innerhalb eines vorgegebenen Wellenlängenbereichs angeordnet ist, wobei die mit einer schwarzen Rückfläche versehene, mindestens einen strukturierten Bereich aufweisende, unbeschichtete Deckplatte so ausgebildet ist, dass bei einem Beobachtungswinkel von 45° und 15° (jeweils bezogen auf die Normale zur Ebene der Deckplatte) und einem Einfallswinkel, der um 45° vom jeweiligen Glanzwinkel (in beiden Richtungen) abweicht, eine Helligkeit L des reflektierten Lichts von mindestens 10, mindestens 15 oder mindestens 20 auftritt.

Erfindungsgemäß kann der eingangs beschriebene Zielkonflikt zwischen einer homogenen Farbe mit geringer Winkelabhängigkeit und gleichzeitig hohem Wirkungsgrad des Solarmoduls sehr zufriedenstellend gelöst werden. Einerseits wird durch die innen und/oder außen strukturierte Oberfläche der Deckplatte Licht mit einer hohen Intensität und geringer Winkelabhängigkeit auch außerhalb des Glanzwinkels reflektiert, da die innen liegende Interferenzschicht eine Grenzfläche mit höherem Brechungsindex darstellt. Bei außen liegender Strukturierung wird das Licht bereits an der Grenzfläche Luft und Deckplatte gebrochen und trifft diffus gestreut aus verschiedensten Winkeln auf die innen liegende Interferenzschicht. Bei nur innen liegender Strukturierung findet die diffuse Streuung an dieser inneren Grenzfläche statt, da erfindungsgemäß viele Oberflächensegmente mit unterschiedlichen Neigungswinkeln zur Verfügung stehen. Andererseits wird durch die optische Interferenzschicht ermöglicht, dass das Licht nur selektiv gefiltert wird und daher der Rest ohne nennenswerte Absorptionsverluste mit hoher Intensität auf den fotovoltaisch aktiven Halbleiter der Solarzellen treffen kann, so dass ein großer Anteil des auftreffenden Lichts mit hohem Wirkungsgrad bzw. möglichst geringem Wirkungsgradverlust des Solarmoduls in elektrischen Strom umwandelbar ist. Zudem wird durch die farbgebende optische Interferenzschicht ein guter homogener Farbeindruck erreicht. Die Interferenzschicht wirkt als Filter mit möglichst schmalbandiger Reflexion und einer breitbandigen Transmission.

Bei einer bevorzugten Ausgestaltung des erfindungsgemäßen Solarmoduls ist auf der Innenfläche der Deckplatte eine optische Interferenzschicht angeordnet, wobei die Innenfläche der Deckplatte keinen strukturierten Bereich aufweist und die Außenfläche mindestens einen strukturierten Bereich aufweist, wobei keine weitere optische Interferenzschicht auf der Außenfläche angeordnet ist. Die Innenfläche ist vorzugsweise glatt (im Rahmen der Produktionsungenauigkeiten). Für die Segmente des strukturierten Bereichs der Außenfläche des Fassadenelements gibt es keine Bedingung für die Rauigkeit. Die strukturierte Außenfläche kann auch größere mikroskopische Rauigkeit aufweisen. An dieser Grenzfläche findet nur Transmission, Brechung und Streuung, jedoch keine Interferenz statt. Die zusätzliche Schicht auf der Außenfläche kann eine (z.B. dünne) Antireflexschicht sein, deren optischer Brechungsindex kleiner ist als jener der Deckplatte. Hierdurch kann eine im Wesentlichen weiße Reflexion der Deckplatte (z.B. Glasplatte) unterdrückt werden und der Sättigungsgrad der Farben steigt. Eine zusätzliche Schicht auf der Außenfläche kann aber auch den gleichen Brechungsindex wie die Deckplatte aufweisen. In diesem Fall dient die Schicht nur dem Schutz der Deckplatte vor Feuchte und andern korrosiven Bestandteilen der Luft. Es hat sich gezeigt, dass durch Ätzen hergestellte satinierte Gläser empfindlicher gegenüber feuchter Hitze sind als plane oder gewalzte Gläser. Im Falle von geätztem Kalknatronglas kann die zusätzliche Schicht zum Beispiel eine dünne gesputterte SiO₂-Schicht sein.

Bei einer weiteren bevorzugten Ausgestaltung des erfindungsgemäßen Solarmoduls ist auf der Innenfläche der Deckplatte eine optische Interferenzschicht angeordnet, wobei die Innenfläche der Deckplatte mindestens einen strukturierten Bereich aufweist und die Außenfläche mindestens einen strukturierten Bereich aufweist, wobei keine weitere optische Interferenzschicht auf der Außenfläche angeordnet ist. Der strukturierte Bereich der Innenfläche und der strukturierte Bereich der Außenfläche können gleich oder voneinander verschieden sein. Für die Segmente des strukturierten Bereichs der Außenfläche des Fassadenelements gibt es keine Bedingung für die Rauigkeit. Die strukturierte Außenfläche kann auch größere mikroskopische Rauigkeit aufweisen. An dieser Grenzfläche findet nur Transmission, Brechung und Streuung, jedoch keine Interferenz statt. Für die Segmente des strukturierten Bereichs der Innenfläche des Fassadenelements gilt die oben genannten Bedingung für die Rauigkeit, da eine optische Interferenzschicht auf dem strukturierten Bereich angeordnet ist. Wenn die Außenfläche strukturiert ist und die Interferenzschicht auf der Innenfläche liegt, entsteht die Winkelstabilität daraus, dass das Licht beim Eintritt durch die strukturierte Außenfläche an den unterschiedlich geneigten Segmenten gebrochen wird, in verschiedenen Winkeln auf die Interferenzschicht trifft und nach Interferenz und Reflexion ein weiteres Mal die strukturierte Außenfläche beim Austritt aus der Deckplatte passiert und dabei wiederum durch Brechung seine Richtung ändert.

Bei einer alternativen Ausgestaltung des erfindungsgemäßen Solarmoduls ist auf der Innenfläche der Deckplatte eine optische Interferenzschicht angeordnet, wobei die Innenfläche der Deckplatte mindestens einen strukturierten Bereich aufweist und die Außenfläche keinen strukturierten Bereich aufweist, wobei keine weitere optische Interferenzschicht auf der Außenfläche angeordnet ist. Die Außenfläche ist vorzugsweise glatt (im Rahmen der Produktionsungenauigkeiten). Für die Segmente des strukturierten Bereichs der Innenfläche des Fassadenelements gilt die oben genannten Bedingung für die Rauigkeit, da eine optische Interferenzschicht auf dem strukturierten Bereich angeordnet ist. Bei dieser Ausgestaltung des erfindungsgemäßen Solarmoduls kann es vorteilhaft sein, wenn die Außenfläche der Deckplatte mit einer (z.B. dünnen) Antireflexschicht beschichtet ist, deren Brechungsindex kleiner ist als jener der Deckplatte. Hierdurch kann eine im Wesentlichen weiße Reflexion einer z.B. gläsernen Deckplatte unterdrückt werden und der Sättigungsgrad der Farben steigt.

Bei einer weiteren bevorzugten Ausgestaltung des erfindungsgemäßen Solarmoduls ist auf der Innenfläche der Deckplatte eine optische Interferenzschicht angeordnet, wobei die Innenfläche der Deckplatte mindestens einen strukturierten Bereich aufweist und die Außenfläche keinen strukturierten Bereich aufweist, wobei eine weitere optische Interferenzschicht auf der Außenfläche angeordnet ist. Die Außenfläche ist vorzugsweise glatt (im Rahmen der Produktionsungenauigkeiten). Für die Segmente des strukturierten Bereichs der Innenfläche des Fassadenelements gilt die oben genannten Bedingung für die Rauigkeit, da eine optische Interferenzschicht auf dem strukturierten Bereich angeordnet ist. Die beiden optischen Interferenzschichten können gleich oder voneinander verschieden sein. Insbesondere können die beiden optischen Interferenzschichten zur Reflexion von Licht innerhalb eines selben Wellenlängenbereichs ausgebildet sein. Möglich ist jedoch auch, dass die beiden optischen Interferenzschichten zur Reflexion von Licht innerhalb verschiedener oder nur teilweise überlappender Wellenlängenbereiche ausgebildet sind. Eine solche obenliegende zusätzliche Schicht kann auch eine dünne Antireflexschicht mit einem Brechungsindex kleiner als jener der Deckplatte sein. Dadurch wird die im wesentlichen weiße Reflexion der Deckplatte (z.B. Glas) unterdrückt und der Sättigungsgrad der Farben steigt. Eine zusätzliche, oben liegende Schicht kann aber auch den gleichen Brechungsindex wie die Deckplatte aufweisen. In diesem Fall dient die Schicht nur dem Schutz des Glases vor Feuchte und anderen korrosiven Bestandteilen der Luft. Es hat sich gezeigt, dass durch Ätzen hergestellte satinierte Gläser empfindlicher gegenüber feuchter Hitze sind als plane oder gewalzte Gläser. Im Falle von geätztem Kalknatronglas kann die zusätzliche Schicht zum Beispiel eine dünne gesputterte SiO₂-Schicht sein. Allen diesen erfindungsgemäßen Ausgestaltungen ist gemeinsam, dass das Licht mindestens einmal die Deckplatte passieren und an der innenliegenden Interferenzschicht reflektiert werden muss, um die gewünschte Farbigkeit mit der verbesserten Winkelstabilität zu erreichen.

Bei einer vorteilhaften Ausgestaltung des erfindungsgemäßen Solarmoduls setzen sich mindestens 80%, besonders bevorzugt mindestens 90%, eines strukturierten Bereichs der Außenfläche oder der Innenfläche (je nachdem welche Fläche strukturiert ist) aus den zur Ebene der Deckplatte geneigten Segmenten zusammen. Durch die Vergrößerung der Anzahl der Segmente kann die Intensität des vom strukturierten Bereich der Oberfläche der Deckplatte auch außerhalb des Glanzwinkels reflektierten Lichts und dessen Winkelstabilität noch weiter gesteigert werden.

Bei einer weiteren vorteilhaften Ausgestaltung des erfindungsgemäßen Solarmoduls haben mindestens 30% der Segmente mindestens eines strukturierten Bereichs einen Neigungswinkel im Bereich von größer als 0° bis maximal 15°, mindestens 40% der Segmente einen Neigungswinkel im Bereich von größer als 15° bis maximal 45° und vorzugsweise, jedoch nicht zwingend, weniger als 10% der Segmente einen Neigungswinkel von größer als 45°. Besonders bevorzugt haben mindestens 40% der Segmente einen Neigungswinkel im Bereich von größer als 0° bis maximal 15°, mindestens 50% der Segmente einen Neigungswinkel im Bereich von größer als 15° bis maximal 45° und vorzugsweise, jedoch nicht zwingend, weniger als 10% der Segmente einen Neigungswinkel von größer als 45°. Falls relativ viele Facetten mit einem kleinen Neigungswinkel von weniger als 15° vorliegen, tritt (wie bei einer unstrukturierten Oberfläche) im Wesentlichen nur eine reflektierte Intensität bei einem Beobachtungswinkel nahe des Glanzwinkels auf, was erfindungsgemäß nicht erwünscht ist. Bei steileren Facetten verringert sich die Winkelabhängigkeit des reflektierten Lichts, jedoch können bei zahlreichen sehr steilen Facetten (größer als 45°) verstärkt Mehrfach-Reflexionen auftreten, was nachteilig ist, da dies in stärkerem Maße zur Einkopplung auch desjenigen Anteils des Lichtes in die Absorberschicht führen kann, dessen Reflexion im Sinne der vorliegenden Erfindung erwünscht ist. Zudem ist es bei vielen Beschichtungsverfahren schwierig, eine konforme Bedeckung mit gleicher Schichtdicke gleichzeitig auf flachen und steile Oberflächensegmente zu gewährleisten. Die Schichtdicke der optischen Interferenzschicht würde also vom Neigungswinkel abhängen, was wiederum zu unerwünschten Winkelabhängigkeiten führt. In dieser Hinsicht am meisten bevorzugt ist eine Ausgestaltung, bei der die Segmente jeweils einen Neigungswinkel aufweisen, der größer als 0° ist und maximal 45° beträgt. Gemäß vorstehender Bedingungen kann eine sehr hohe Intensität des reflektierten Lichts auch außerhalb des Glanzwinkels bei zugleich besonders geringer Winkelabhängigkeit der Intensität erreicht werden.

Die Strukturen sind bevorzugt nicht-periodisch und anisotrop. Für spezielle optische Effekte können jedoch auch periodische Strukturen und/oder anisotrope Strukturen zur Anwendung kommen. Periodische und anisotrope Strukturen wie Pyramiden, tetragonale oder hexagonale Wabenstrukturen oder Halbkugeln lassen sich gut mit Walzen beim Glasziehen herstellen. Sie können zu attraktiven Glanz und Farbeffekten verwendet werden. Wenn die Oberflächenstrukturen die oben genannten Bedingungen erfüllen, zeigen die Solarmodule wiederum eine deutlich verringerte Abnahme der Farbigkeit für Winkel außerhalb der Glanzwinkel, jedoch sind die Winkelabhängigkeiten dann anisotrop in Bezug auf die Orientierung in der Modulebene.

Die mindestens eine optische Interferenzschicht kann eine oder mehrere Brechungsschichten enthalten und insbesondere aus diesen bestehen. Eine Brechungsschicht besteht aus einem selben Material (mit gleicher Zusammensetzung) und weist insbesondere über die Schichtdicke hinweg einen homogenen (gleichen) Brechungsindex auf. Enthält die optische Interferenzschicht mehrere Brechungsschichten, bestehen mindestens zwei Brechungsschichten aus einem voneinander verschiedenen Material und haben einen unterschiedlichen Brechungsindex. Vorteilhaft weist mindestens eine Brechungsschicht einen Brechungsindex n von größer als 1,7, vorzugsweise größer als 2,0 und besonders bevorzugt größer als 2,3 auf. Grundsätzlich gilt, dass je größer der Brechungsindex ist, desto geringer ist die Winkelabhängigkeit des reflektierten Lichts, so dass die Winkelabhängigkeit des Farbeindrucks weiter reduziert werden kann.

Vorteilhaft enthält die optische Interferenzschicht mindestens eine Verbindung, gewählt aus TiOₓ, ZrOₓ, SiC und Si₃N₄. Weist die optische Interferenzschicht zwei, drei oder mehr Lagen auf, enthält die optische Interferenzschicht vorzugsweise mindestens eine Verbindung, gewählt aus MgF₂, Al₂O₃, SiO₂ und Siliziumoxinitrid. Dies sind Verbindungen mit einem relativ niedrigen Brechungsindex.

In dem erfindungsgemäßen Solarmodul kann aufgrund der Kombination einer strukturierten Oberfläche mit einer optischen Interferenzschicht, die nur eine geringe Anzahl an Brechungsschichten aufweist (z.B. ein bis drei Brechungsschichten) schon ein guter Farbeindruck erreicht werden. Durch die geringe Anzahl an Brechungsschichten wird die Herstellung des Solarmoduls vereinfacht und die Produktionskosten verringern sich.

Vorteilhaft enthält mindestens eine optische Interferenzschicht (insbesondere alle optischen Interferenzschichten) des Solarmoduls genau eine Brechungsschicht (oder besteht aus dieser), deren Brechungsindex n größer als 1,9, bevorzugt größer als 2,3, ist.

Gleichermaßen vorteilhaft enthält mindestens eine optische Interferenzschicht (insbesondere alle optischen Interferenzschichten) des Solarmoduls genau zwei Brechungsschichten (oder besteht aus diesen), wobei eine erste Brechungsschicht mit einen ersten Brechungsindex n1 auf der Deckplatte mit einem Brechungsindex nd vorliegt und eine zweite Brechungsschicht mit einem zweiten Brechungsindex n2 auf der ersten Brechungsschicht vorliegt. Für die Beträge (Absolutwerte) der Differenzen der Brechungsindizes gilt: |n1-nd| > 0,3 und |n2-n1| > 0,3 und mindestens einer der Brechungsindizes n1 oder n2 ist größer als 1,9, bevorzugt größer als 2,3.

Gleichermaßen vorteilhaft enthält mindestens eine optische Interferenzschicht (insbesondere alle optischen Interferenzschichten) des Solarmoduls genau drei Brechungsschichten (oder besteht aus diesen), wobei eine erste Brechungsschicht mit einen ersten Brechungsindex n1 auf der Deckplatte mit einem Brechungsindex nd vorliegt, eine zweite Brechungsschicht mit einem zweiten Brechungsindex n2 auf der ersten Brechungsschicht vorliegt und eine dritte Brechungsschicht mit einem dritten Brechungsindex n3 auf der zweiten Brechungsschicht vorliegt. Für die Beträge (Absolutwerte) der Differenzen der Brechungsindizes gilt: |n3-n2| > 0,3 und |n2-n1| > 0,3 und |n1-nd| > 0,3. Dabei verhalten sich die Werte der Brechungsindizes alternierend: entweder gilt n1 > n2 und n3 > n2 oder es gilt n1 < n2 und n3 < n2. Zudem ist mindestens einer der Brechungsindizes n1, n2 oder n3 größer als 1,9, bevorzugt größer als 2,3.

Durch die optischen Interferenzschichten mit genau einer, genau zwei oder genau drei Brechungsschichten kann bei vereinfachter Herstellung und geringeren Produktionskosten des Solarmoduls ein homogener Farbeindruck des Solarmoduls erzielt werden. Durch zwei- oder dreilagige Schichten kann die Farbkraft, d.h. Helligkeit und Sättigung, also die Reflexion in einem bestimmten engen Wellenbereich erhöht werden. Durch relativ hohe Brechungsindizes wird die Winkelabhängigkeit reduziert. Interferenzschichten aus Schichtstapeln mit mehr als drei Schichten in Kombination mit der erfindungsgemäß strukturierten Deckplatte und den dargestellten Ausgestaltungen liegen ebenfalls im Bereich der Erfindung, sind aber komplexer in der Herstellung. Mit einer Vierfachschicht aus Brechschichten mit alternierend hohen und niedrigen Brechungsindizes kann beispielsweise die Bandbreite des reflektierten Lichts noch weiter reduziert werden bei verbesserter Transmission.

Im strukturierten Bereich der Deckplatte tritt eine Reflexion der einfallenden Lichtstrahlung auch außerhalb des Glanzwinkels mit relativ hoher Intensität auf. Der strukturierte Bereich ist zu diesem Zweck vorzugsweise so ausgebildet, dass ein Reflexions-Haze von mehr als 50%, besonders bevorzugt mehr als 90%, vorliegt. Der Reflexions-Haze lässt sich durch ein im Handel verfügbares Haze-Messgerät bestimmen. Nach ASTM D1003 ist Haze das Verhältnis aus diffusem Anteil des reflektierten Lichts zur Gesamtreflexion.

Wie oben ausgeführt, gilt für alle Ausgestaltungen, in denen die strukturierte Seite innen ist und die Interferenzschicht unmittelbar auf dieser strukturierten Seite liegt, dass die Segmente eine mittlere Rauigkeit von weniger als 15% der Schichtdicke der optischen Interferenzschicht haben sollen, wodurch eine konstruktive bzw. destruktive Interferenz des reflektierten Lichts ermöglicht ist. Vorteilhaft erstreckt sich diese Zone über die gesamte Deckplatte. Gemäß einer Ausgestaltung der Erfindung weist der strukturierte Bereich mindestens eine weitere Zone, d.h. (Teil-)Bereich, auf, in dem die Segmente jeweils eine solche mittlere Rauigkeit aufweisen, dass eine Interferenz an der optischen Interferenzschicht nicht auftritt. Beispielsweise haben die Segmente dort eine mittlere Rauigkeit von 50% bis 100% der Schichtdicke der Interferenzschicht. In diesen Zonen weist das Solarmodul keine durch die optische Interferenzschicht erzeugte Farbe auf.

Die Erfindung bezieht sich weiterhin auf ein Verfahren zur Herstellung eines erfindungsgemäßen Solarmoduls wie es vorstehend beschrieben ist.

Das Verfahren umfasst zur Bearbeitung der Deckplatte die folgenden Schritte:
In einem ersten Verfahrensschritt a) wird eine ebene transparente Deckplatte bereitgestellt, die eine Außenfläche, welche der äußeren Umgebung zugewandt sein soll, und eine gegenüberliegende Innenfläche aufweist.

Anschließend wird aus den folgenden vier (alternativen) Verfahrensschritten ein einziger zweiter Verfahrensschritt b1), b2), b3) oder b4) ausgewählt und durchgeführt:
b1) Strukturieren der Außenfläche mindestens in einem Bereich und Aufbringen einer optischen Interferenzschicht auf die Innenfläche. In diesem Fall wird keine weitere optische Interferenzschicht auf die Außenfläche aufgebracht. Ferner wird die Innenfläche nicht strukturiert.
b2) Strukturieren der Außenfläche mindestens in einem Bereich, Strukturieren der Innenfläche mindestens in einem Bereich und Aufbringen einer optischen Interferenzschicht auf den strukturierten Bereich der Innenfläche. In diesem Fall wird keine weitere optische Interferenzschicht auf die Außenfläche aufgebracht.
b3) Strukturieren der Innenfläche mindestens in einem Bereich und Aufbringen einer optischen Interferenzschicht auf den strukturierten Bereich der Innenfläche. In diesem Fall wird keine weitere optische Interferenzschicht auf die Außenfläche aufgebracht. Ferner wird die Außenfläche nicht strukturiert.
b4) Strukturieren der Innenfläche mindestens in einem Bereich, Aufbringen einer optischen Interferenzschicht auf den strukturierten Bereich der Innenfläche und Aufbringen einer weiteren optischen Interferenzschicht auf die Außenfläche. In diesem Fall wird die Außenfläche nicht strukturiert.

In obigem Verfahren umfasst das Strukturieren der Außenfläche bzw. Innenfläche auch das Aufbringen einer mit mindestens einem strukturierten Bereich versehenen, transparenten Schicht auf die Deckplatte, welche die Außenfläche bzw. Innenfläche bildet.

Des Weiteren erstreckt sich die Erfindung auf die Verwendung des erfindungsgemäßen Solarmoduls als (integraler) Bestandteil einer Gebäudehülle (Gebäudewand) oder einer freistehenden Wand, beispielsweise eine Sichtschutz- oder Lärmschutzwand.

Die verschiedenen Ausgestaltungen der Erfindung können einzeln oder in beliebigen Kombinationen realisiert sein. Insbesondere sind die vorstehend genannten und nachstehend zu erläuternden Merkmale nicht nur in den angegebenen Kombinationen, sondern auch in anderen Kombinationen oder in Alleinstellung einsetzbar, ohne den Rahmen der vorliegenden Erfindung zu verlassen.

Die Erfindung wird im Weiteren näher erläutert, wobei Bezug auf die beigefügten Zeichnungen genommen wird. Es zeigen in vereinfachter, nicht maßstäblicher Darstellung:
- Fig. 1: ein Ausführungsbeispiel für ein erfindungsgemäßes Solarmodul in einer schematischen Querschnittansicht;
- Fig. 2: den Grundaufbau des erfindungsgemäßen Solarmoduls in einer schematischer Querschnittansicht;
- Fig. 3: eine schematische Querschnittansicht eines vergrößerten Ausschnitts der Deckplatte von Figur 2 gemäß einer Ausgestaltung des erfindungsgemäßen Solarmoduls;
- Fig. 4: eine schematische Darstellung typischer Lichtverhältnisse eines als Fassadenelement ausgebildeten Solarmoduls;
- Fig. 5: eine schematische Darstellung beispielhafter Lichtwege bei Reflexion im strukturierten Bereich der Deckplatte des Solarmoduls von Figur 2;
- Fig. 6: eine schematische Darstellung der Interferenz von Lichtstrahlen in der optischen Interferenzschicht;
- Fig. 7-10: weitere Ausgestaltungen des erfindungsgemäßen Solarmoduls;
- Fig. 11: eine schematische Darstellung des Messverfahrens zur MehrwinkelFarbmessung;
- Fig. 12: ein Diagramm zur Darstellung der Messwerte einer winkelabhängigen Messung der Helligkeit verschiedener Glasscheiben;
- Fig. 13-14: Höhenprofile verschiedener Glasscheiben;
- Fig. 15: ein Diagramm zur Darstellung der Winkelverteilungen der Segmente verschiedener Glasscheiben;
- Fig. 16-18: Diagramme zur Darstellung verschiedener Eigenschaften von strukturierten Deckplatten;
- Fig. 19: ein Ablaufdiagramm zur Veranschaulichung des erfindungsgemäßen Verfahrens.

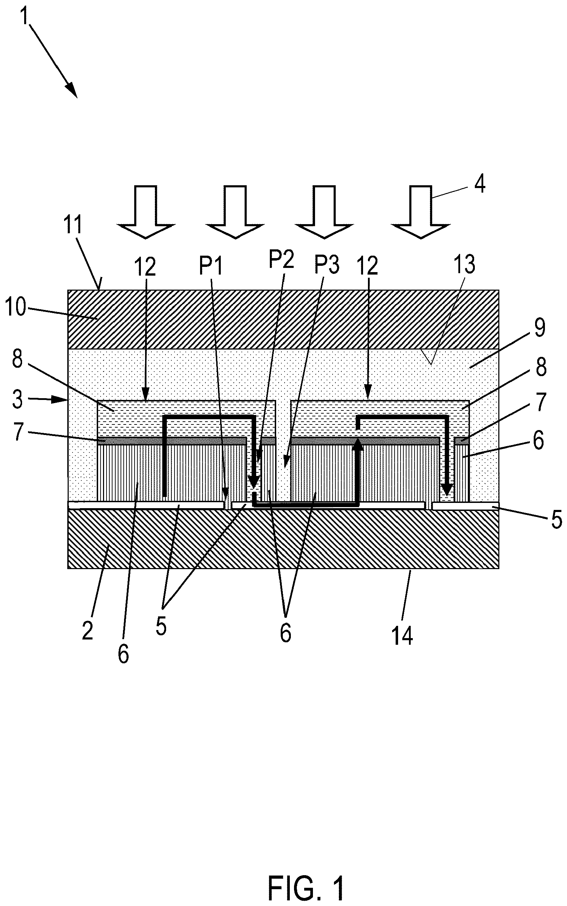

In Figur 1 ist ein insgesamt mit der Bezugszahl 1 bezeichnetes Solarmodul gemäß vorliegender Erfindung in schematischer Weise anhand einer Querschnittansicht (Schnitt senkrecht zur Moduloberfläche) veranschaulicht. Das beispielhaft in Form eines Dünnschichtsolarmoduls ausgebildete Solarmodul 1 umfasst eine Mehrzahl von in integrierter Form seriell miteinander verschalteten Solarzellen 12, von denen in stark vereinfachter Weise nur zwei dargestellt sind. Es versteht sich, dass im Solarmodul 1 in aller Regel eine Vielzahl von Solarzellen 12 (beispielsweise ca. 100-150) seriell verschaltet sind. Das Solarmodul 1 weist eine Verbundscheibenstruktur in Substratkonfiguration auf. Es umfasst ein rückseitiges Substrat 2 mit einem darauf aufgebrachten Schichtenaufbau 3 aus dünnen Schichten, wobei der Schichtenaufbau 3 auf einer lichteintrittsseitigen Oberfläche des Substrats 2 angeordnet ist. Das Substrat 2 ist hier beispielsweise als starre, ebene Glasplatte mit einer relativ hohen Lichtdurchlässigkeit ausgebildet, wobei gleichermaßen andere elektrisch isolierende Materialien mit gewünschter Festigkeit und inertem Verhalten gegenüber den durchgeführten Prozessschritten eingesetzt werden können.

Der Schichtenaufbau 3 umfasst eine auf der Oberfläche des Substrats 2 angeordnete opake Rückelektrodenschicht 5, die beispielsweise aus einem lichtundurchlässigen Metall wie Molybdän (Mo) besteht und durch Aufdampfen oder magnetfeldunterstützte Kathodenzerstäubung (Sputtern) auf das Substrat 2 aufgebracht wurde. Die Rückelektrodenschicht 5 hat beispielsweise eine Schichtdicke im Bereich von 300 nm bis 600 nm. Auf der Rückelektrodenschicht 5 ist eine fotovoltaisch aktive (opake) Absorberschicht 6 aufgebracht, die aus einem mit Metallionen dotierten Halbleiter besteht, dessen Bandabstand in der Lage ist, einen möglichst großen Anteil des Sonnenlichts zu absorbieren. Die Absorberschicht 6 besteht beispielsweise aus einem p-leitenden Chalkopyrit-Halbleiter, beispielsweise eine Verbindung der Gruppe Cu(In/Ga)(S/Se)₂, insbesondere Natrium(Na)-dotiertes Cu(In/Ga)(S/Se)₂. In vorstehender Formel können Indium (In) und Gallium (Ga) sowie Schwefel (S) und Selen (Se) wahlweise oder in Kombination vorhanden sein. Die Absorberschicht 6 hat eine Schichtdicke, die beispielsweise im Bereich von 1-5 µm liegt und insbesondere ca. 2 µm beträgt. Für die Herstellung der Absorberschicht 6 werden typischer Weise verschiedene Materiallagen beispielsweise durch Sputtern aufgebracht, die anschließend durch Erwärmen in einem Ofen, gegebenenfalls in einer S- und/oder Se-haltigen Atmosphäre, zum Verbindungshalbleiter thermisch umgesetzt werden (RTP = Rapid Thermal Processing). Dem Fachmann ist diese Art der Herstellung eines Verbindungshalbleiters wohlbekannt, so dass hier nicht näher darauf eingegangen werden muss. Auf die Absorberschicht 6 ist eine Pufferschicht 7 abgeschieden, die hier beispielsweise aus einer Einzellage Cadmiumsulfid (CdS) und einer Einzellage aus intrinsischem Zinkoxid (i-ZnO) besteht, was in Figur 1 nicht näher dargestellt ist. Auf die Pufferschicht 7 ist eine Frontelektrodenschicht 8 beispielsweise durch Sputtern aufgebracht. Die Frontelektrodenschicht 8 ist für Strahlung im sichtbaren Spektralbereich transparent ("Fensterelektrode"), so dass das einstrahlende Sonnenlicht 4 (in Fig. 1 durch Pfeile veranschaulicht) nur gering geschwächt wird. Die Frontelektrodenschicht 8 basiert beispielsweise auf einem dotierten Metalloxid, beispielsweise n-leitendes Aluminium (Al)-dotiertes Zinkoxid (ZnO). Eine solche Frontelektrodenschicht 8 wird allgemein als TCO-Schicht (TCO = Transparent Conductive Oxide) bezeichnet. Die Schichtdicke der Frontelektrodenschicht 8 beträgt beispielsweise ca. 500 nm. Durch die Frontelektrodenschicht 8 wird gemeinsam mit der Pufferschicht 7 und der Absorberschicht 6 ein Heteroübergang (d.h. Abfolge von Schichten vom entgegen gesetzten Leitungstyp) gebildet. Dabei kann die Pufferschicht 7 eine elektronische Anpassung zwischen der Absorberschicht 6 und der Frontelektrodenschicht 8 bewirken.

Zum Schutz vor Umwelteinflüssen ist auf dem Schichtenaufbau 3 eine (Kunststoff-)Klebeschicht 9 aufgebracht, die zur Verkapselung des Schichtenaufbaus 3 dient. Verklebt mit der Klebeschicht 9 ist eine für Sonnenlicht transparente front- bzw. lichteintrittsseitige Deckplatte 10, die hier beispielsweise in Form einer starren (ebenen) Glasplatte aus extraweißem Glas mit geringem Eisengehalt ausgebildet ist. Die Deckplatte 10 dient zur Versiegelung und für einen mechanischen Schutz des Schichtenaufbaus 3. Die Deckplatte 10 verfügt über eine den Solarzellen 12 zugewandte Innenfläche 13 und eine von den Solarzellen 12 abgewandte Außenfläche 11, welche gleichzeitig die Moduloberfläche bzw. Moduloberseite ist. Über die Außenfläche 11 kann das Solarmodul 1 Sonnenlicht 4 aufnehmen, um an resultierenden Spannungsanschlüssen (+,-) eine elektrische Spannung zu erzeugen. Ein Strompfad ist in Fig. 1 durch seriell angeordnete Pfeile veranschaulicht. Die Deckplatte 10 und das Substrat 2 sind durch die Klebeschicht 9 fest miteinander verbunden ("laminiert"), wobei die Klebeschicht 9 hier beispielsweise als thermoplastische Klebeschicht ausgebildet ist, die durch Erwärmen plastisch verformbar wird und beim Abkühlen die Deckplatte 10 und das Substrat 2 fest miteinander verbindet. Die Klebeschicht 9 kann im Herstellungsprozess als Laminierfolie bereitgestellt werden und besteht hier beispielsweise aus PVB. Die Deckplatte 10 und das Substrat 2 mit den in die Klebeschicht 9 eingebetteten Solarzellen 12 formen gemeinsam einen laminierten Verbund. Die Modulrückseite 14 ist durch die den Solarzellen 12 abgewandte Oberfläche des Substrats 2 gegeben.

Für die Ausbildung und Serienverschaltung der Solarzellen 12 ist der Schichtenaufbau 3 unter Einsatz einer geeigneten Strukturierungstechnologie, beispielsweise Laserschreiben und/oder mechanische Abtragung, strukturiert. Es ist gängig zu diesem Zweck unmittelbare Abfolgen von jeweils drei Strukturierungslinien P1-P2-P3 in den Schichtenaufbau 3 einzubringen. Hierbei wird durch erste Strukturierungslinien P1 mindestens die Rückelektrodenschicht 5 unterteilt, wodurch die Rückelektroden der Solarzellen 12 erzeugt werden. Durch zweite Strukturierungslinien P2 wird mindestens die Absorberschicht 6 unterteilt, wodurch die fotovoltaisch aktiven Bereiche (Absorber) der Solarzellen 12 erzeugt werden. Durch dritte Strukturierungslinien P3 wird mindestens die Frontelektrodenschicht 8 unterteilt, wodurch die Frontelektroden der Solarzellen 12 erzeugt werden. Mittels der zweiten Strukturierungslinie P2 ist die Frontelektrode einer Solarzelle 12 mit der Rückelektrode einer angrenzenden Solarzelle 12 elektrisch verbunden, wobei die Frontelektrode die Rückelektrode beispielsweise direkt kontaktiert. In dem Ausführungsbeispiel von Figur 1 sind die Gräben der ersten Strukturierungslinien P1 durch Material der Absorberschicht 6 verfüllt. Die Gräben der zweiten Strukturierungslinien P2 sind durch Material der Frontelektrodenschicht 8 verfüllt und die Gräben der dritten Strukturierungslinien P3 sind durch die Klebeschicht 9 verfüllt. Jede unmittelbare Abfolge aus erster, zweiter und dritter Strukturierungslinie P1-P2-P3 bildet eine Strukturierungszone zur Serienverschaltung zweier unmittelbar benachbarter Solarzellen 12.

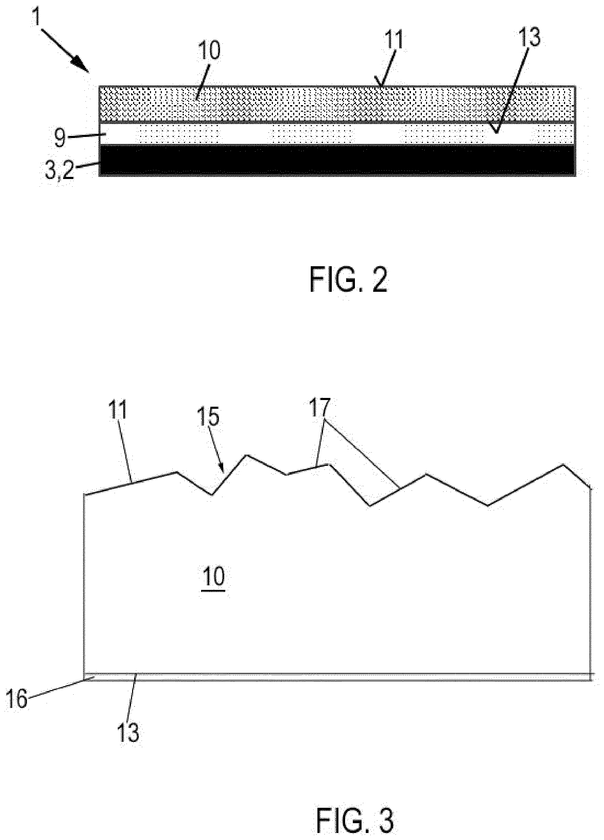

Es wird nun Bezug auf Figur 2 genommen, worin der grundsätzliche Aufbau des erfindungsgemäßen Solarmoduls 1 gezeigt ist. Das Solarmodul 1 umfasst die Deckplatte 10 (z.B. Frontglas) und den auf das rückseitige Substrat 2 aufgebrachten Schichtenaufbau 3, die durch die Klebeschicht 9 (Laminierungsfolie) fest miteinander verbunden sind. Das für das Solarmodul 1 farbgebende Element ist die beschichtete Deckplatte 10, deren Außenfläche 11 gegen das einfallende Licht zeigt und deren Innenfläche 13 über die Klebeschicht 9 mit den fotovoltaischen Solarzellen 12 (Siliziumwafer- oder Dünnschichtsolarzellen) verbunden ist. Das Solarmodul 1 kann insbesondere wie in Figur 1 beschrieben aufgebaut sein. Die Deckplatte 10 ist hier beispielsweise eine Glasscheibe mit möglichst geringer Absorption und besteht zum Beispiel aus Kalknatronglas. Die Außenfläche 11 und/oder die Innenfläche 13 der Deckplatte 10 ist strukturiert (z.B. durch Ätzung, Sandstrahlen oder Walzen beim Ziehprozess) und weist jedenfalls auf der Innenfläche 13, sowie gegebenenfalls auf der Außenfläche 11, eine optische Interferenzschicht auf, was in Figur 1 und Figur 2 nicht dargestellt ist (siehe Figur 3).

In Figur 3 ist anhand eines vergrößerten Ausschnitts der Deckplatte 10 des Solarmoduls 1 von Figur 2 eine Ausgestaltung des erfindungsgemäßen Solarmoduls 1 veranschaulicht. Die Außenfläche 11 der Deckplatte 10 ist in einem Bereich 15 strukturiert, welcher sich im vorliegenden Beispiel über die komplette Außenfläche 11 erstreckt, d.h. Außenfläche 11 und strukturierter Bereich 15 sind identisch. Unmittelbar auf der Innenfläche 13 ist eine optische Interferenzschicht 16 angeordnet. Im strukturierten Bereich 15 ist die Außenfläche 11 mit einem Höhenprofil versehen, das Berge und Täler aufweist. Hierbei bestehen mehr als 50% der Außenfläche 11 aus ebenen Segmenten 17, deren Ebenen jeweils zur Ebene der Deckplatte 10 geneigt sind, d.h. einen von Null verschiedenen Winkel aufweisen. Ein mittlerer Höhenunterschicht zwischen den höchsten Punkten (Berge) und niedrigsten Punkten (Täler) der Außenfläche 11 beträgt mindestens 5 µm und beispielsweise maximal 20% der Dicke der transparenten Deckplatte 10. Bezogen auf die Ebene der Deckplatte 10 haben mindestens 20% der Segmente einen Neigungswinkel im Bereich von größer als 0° bis maximal 15°, mindestens 30% der Segmente einen Neigungswinkel im Bereich von größer als 15° bis maximal 45° und weniger als 30% der Segmente 17 einen Neigungswinkel von größer als 45°. Im Ausführungsbeispiel von Figur 3 haben alle Segmente einen Neigungswinkel von maximal 45°. Die optische Interferenzschicht 16 ist dünn und weist eine Schichtdicke beispielsweise im Bereich von 0,1 bis einigen (z.B. 5) Mikrometer auf. Ferner hat die optische Interferenzschicht 16 einen Brechungsindex n von größer als 1,7, vorzugsweise größer als 2,0 und besonders bevorzugt größer als 2,3, sowie eine möglichst geringe Absorption in Bezug auf das einfallende Licht. Die optische Interferenzschicht 16 kann ein- oder mehrlagig ausgebildet sein, d.h. aus einer oder mehreren Brechungsschichten bestehen. Jede Brechungsschicht weist einen bestimmten Brechungsindex auf und besteht aus demselben Material. Beispielsweise besteht die optische Interferenzschicht 16 aus MgO, SiONx, Si₃N₄, ZrO₂, TiOx und/oder SiC. Die elektrische Leitfähigkeit der einzelnen Brechungsschichten, insbesondere der optischen Interferenzschicht 16, sollte möglichst gering sein.

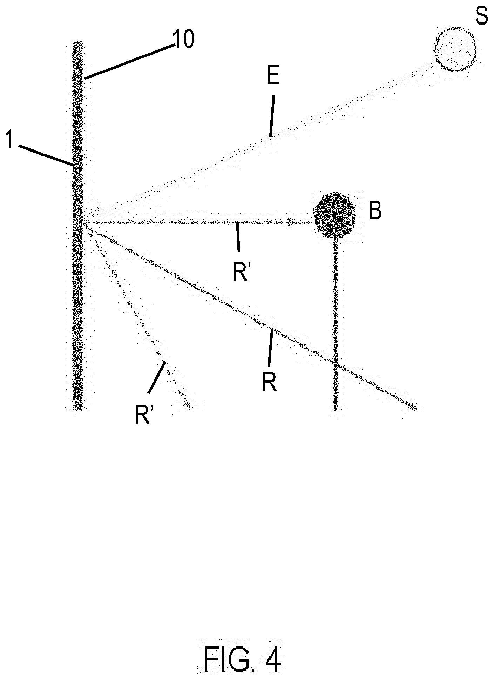

Im Weiteren wird die Funktionsweise der Strukturierung der Außenfläche 11 der Deckplatte 10 näher beschrieben. Sei zunächst Figur 4 betrachtet, worin beispielhaft typische Lichtverhältnisse bei einem als Fassadenelement ausgebildeten Solarmodul 1 veranschaulicht sind. Demnach trifft Licht von der Sonne S direkt auf die Deckplatte 10 und wird im Glanzwinkel (Einfallswinkel = Ausfallswinkel, bezogen auf Oberflächennormale der Ebene der Deckplatte) reflektiert. Der einfallende Lichtstrahl E und der im Glanzwinkel reflektierte Lichtstrahl R sind gezeigt. Neben dem reflektierten Lichtstrahl R wird das einfallende Licht auch außerhalb des Glanzwinkels diffus gestreut aufgrund der erfindungsgemäßen Konfiguration von mindestens einer strukturierten Seite innen oder außen und der innen liegenden Interferenzschicht. Zwei diffus gestreute Lichtstrahlen R' sind beispielhaft gezeigt. Der Farbeffekt entsteht durch Reflexion, Streuung und Interferenz. Steht ein Beobachter B vor dem Solarmodul 1 und blickt senkrecht auf die Deckplatte 10 vor ihm, trifft sein Auge nur in den seltensten Fällen das direkt reflektierte Licht R (d.h. der Beobachter steht meist nicht im Glanzwinkel). Dies ist in Figur 4 veranschaulicht, wo sich der Beobachter B außerhalb des Glanzwinkels befindet und nur den diffus gestreuten Lichtstrahl R' sieht. Bei einer glatten Deckplatte ohne strukturierte Bereiche innen oder außen ist die Intensität des diffus gestreuten Lichts R' relativ gering und weist eine starke Winkelabhängigkeit auf. Erst wenn der diffus gestreute Anteil ausreichend groß ist, gibt es eine deutliche Farbe mit zufriedenstellender Intensität (Helligkeit, L-Wert).

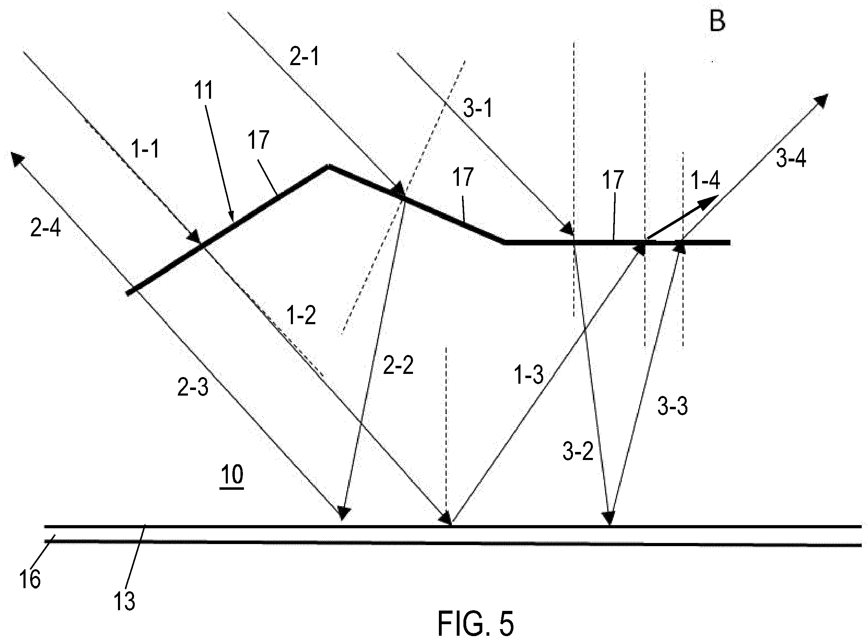

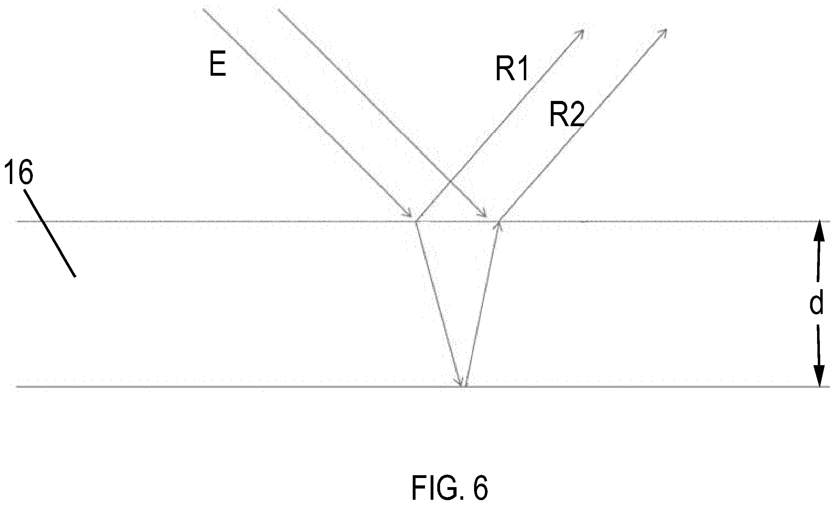

Anhand von Figur 5 wird die Funktion der strukturierten Außenfläche 11 in Kombination mit der innenseitigen Interferenzschicht 16 gemäß der Ausgestaltung von Figur 3 näher erläutert. Darin gezeigt sind beispielhaft verschiedene Lichtwege für verschieden geneigte Segmente 17 der Deckplatte 10. Beispielhaft sind drei Segmente 17 gezeigt, wobei das rechte Segment 17 parallel zur Ebene der Deckplatte 10 liegt und die beiden anderen Segmente 17 einen von Null verschiedenen Winkel zur Ebene der Deckplatte 10 haben. Die Reflexion der Lichtstrahlen an der Interferenzschicht 16 ist vereinfacht dargestellt. Die Reflexion an der Interferenzschicht 16 ist im Zusammenhang mit Figur 6 weiter unten erläutert. In Figur 5 sind die Lichtwege für drei Lichtstrahlen gezeigt, die jeweils in einem selben Winkel zur Normalen der Ebene der Deckplatte 10 auf die verschieden geneigten Segmente 17 der Außenfläche 11 der Deckplatte 10 treffen. Das jeweilige Lot auf die Segmente 17 ist gestrichelt eingezeichnet. Aufgrund der verschieden geneigten Segmente 17 werden die Lichtstrahlen in verschiedener Weise reflektiert. Ein erster Lichtstrahl 1-1 trifft auf ein Segment 17, quert als gebrochener Lichtstrahl 1-2 die Deckplatte 10, wird als Lichtstrahl 1-3 von der Interferenzschicht 16 (im Glanzwinkel) reflektiert, und tritt als gebrochener Lichtstrahl 1-4 von der Deckplatte 10 zur äußeren Umgebung hin aus. Der letztlich von der Deckplatte 10 reflektierte Lichtstrahl 1-4 weist einen anderen Winkel zur Normalen auf die Ebene der Deckplatte 10 auf als der einfallende Lichtstrahl 1-1, so dass keine Reflexion im Glanzwinkel sondern Streuung vorliegt. In entsprechender Weise trifft ein zweiter Lichtstrahl 2-1 auf ein anderes Segment 17, quert als gebrochener Lichtstrahl 2-2 die Deckplatte 10, wird als Lichtstrahl 2-3 von der Interferenzschicht 16 reflektiert, und tritt als gebrochener Lichtstrahl 2-4 von der Deckplatte 10 zur äußeren Umgebung hin aus. Der reflektierte Lichtstrahl 2-4 tritt annähernd entgegen der Einfallsrichtung des Lichtstrahls 2-1 von der Deckplatte 10 aus, was ebenfalls ein Streuvorgang und keine Reflexion im Glanzwinkel ist. Ein dritter Lichtstrahl 3-1 trifft auf ein weiteres Segment 17, quert als gebrochener Lichtstrahl 3-2 die Deckplatte 10, wird als Lichtstrahl 3-3 von der Interferenzschicht 16 reflektiert, und tritt als gebrochener Lichtstrahl 3-4 von der Deckplatte 10 zur äußeren Umgebung hin aus. Dieses Segment 17 liegt parallel zur Ebene der Deckplatte 10, so dass der Lichtstrahl 2-4 im Glanzwinkel reflektiert wird. Wesentlich hierbei ist, dass durch jene Segmente 17, die zur Ebene der Deckplatte 10 geneigt sind, aufgrund der Brechung am jeweiligen Segment 17 und anschließende Reflexion an der Grenzfläche mit Interferenzschicht und weiterer Brechung an der strukturierten Oberfläche insgesamt eine starke Reflexion auch außerhalb des Glanzwinkels (bezogen auf die Ebene der Deckplatte 10) auftritt, so dass in Kombination mit der Interferenzschicht 16 eine homogene Farbwirkung des reflektierten Lichts erreicht wird. In Figur 5 ist beispielhaft die Position eines Betrachters B dargestellt, der sich außerhalb des Glanzwinkels befindet. Aufgrund der relativ stark (diffus) streuenden Deckplatte 10 mit äußerer Strukturierung und innen liegender Interferenzschicht finden sich für verschiedene Betrachtungswinkel außerhalb des Glanzwinkels meist passende Lichtwege, die mindestens einmal die Deckplatte bis zur innen liegenden Interferenzschicht passiert haben. Hierdurch ergibt sich ein Farbeindruck, der weitaus weniger richtungsabhängig ist als bei herkömmlichen Modulen ohne strukturierten Bereich 15.

In Figur 6 sind die Reflexionsverhältnisse an der optischen Interferenzschicht 16 mit Schichtdicke d veranschaulicht. Gezeigt ist ein auf die Interferenzschicht 16 treffender Lichtstrahl E (nach Passage durch die Deckplatte 10), der sowohl an der zur Deckplatte 10 näheren Grenzfläche reflektiert wird (reflektierter Strahl R1) als auch an der von der Deckplatte 10 weiter entfernten Grenzfläche (hier zur Verkapselungschicht) reflektiert wird (reflektierter Strahl R2). Falls der Gangunterschied der beiden Lichtstrahlen R1, R2 einem Vielfachen der Wellenlänge des einfallenden Lichtstrahls entspricht, tritt konstruktive Interferenz auf (Einfallswinkel = Ausfallswinkel), bei einem Gangunterschied von einem Vielfachen der halben Wellenlänge destruktive Interferenz. Bei Beleuchtung mit weißem Licht wirkt die optische Interferenzschicht als Farbfilter, da konstruktive Interferenz, abhängig vom Brechungsindex n und der Schichtdicke d, nur für Licht geeigneter Wellenlänge auftritt. Hierbei ist α der Winkel der reflektierten Strahlen R1, R2, zur Oberflächennormalen.

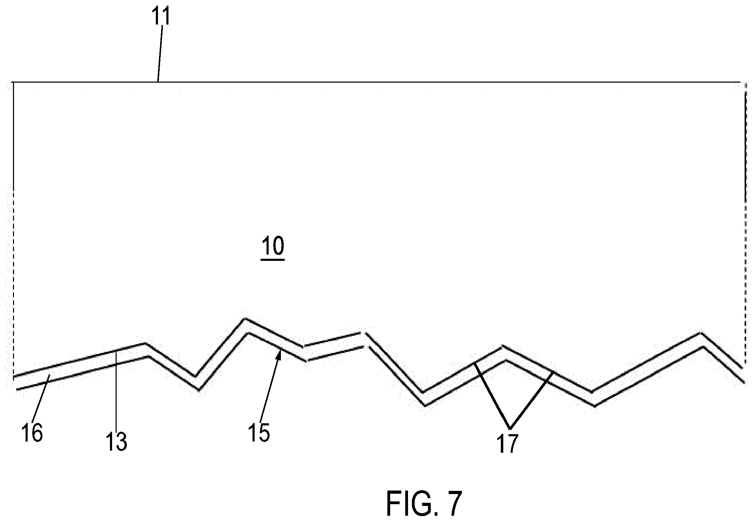

Es wird nun Bezug auf Figur 7 genommen, worin eine weitere Ausgestaltung des erfindungsgemäßen Solarmoduls 1 gezeigt ist. Um unnötige Wiederholungen zu vermeiden, werden lediglich die Unterschiede zur Ausgestaltung von Figur 3 beschrieben und ansonsten wird auf obige Ausführungen Bezug genommen. Demnach weist das Solarmodul 1 auf der Innenfläche 13 der Deckplatte 10 einen strukturierten Bereich 15 auf, wobei auf dem strukturierten Bereich 15 eine optische Interferenzschicht 16 (solarzellenseitig) angeordnet ist.

Im strukturierten Bereich 15 ist die Innenfläche 13 mit einem Höhenprofil versehen, das Berge und Täler aufweist. Hierbei bestehen mehr als 50% der Außenfläche 11 aus ebenen Segmenten 17, deren Ebenen jeweils zur Ebene der Deckplatte 10 geneigt sind, d.h. einen von Null verschiedenen Winkel aufweisen, wobei die Segmente jeweils eben sind und eine Segmentfläche von mindestens 1 µm² haben, wobei die Segmente 17 jeweils eine mittlere Rauigkeit von weniger als 15% einer Schichtdicke der optischen Interferenzschicht 16 auf der Innenfläche 13 haben. Die optische Interferenzschicht 16 ist dünn und folgt der Oberfläche des strukturierten Bereichs 15. Der strukturierte Bereich 15 und die optische Interferenzschicht 16 können jeweils analog zu jenen der Ausgestaltung von Figur 3 ausgebildet sein. Die Außenfläche 11 der Deckplatte 10 weist keinen strukturierten Bereich 15 auf und ist im Rahmen der Produktionsungenauigkeiten glatt. Die Bedingung für die Rauigkeit der Segmente 17 des strukturierten Bereichs ergibt sich daraus, dass Interferenz an dünnen Schichten nur zustande kommt, wenn die Schichtdicken gleichmäßig sind und die Grenzflächen hinreichend glatt sind.

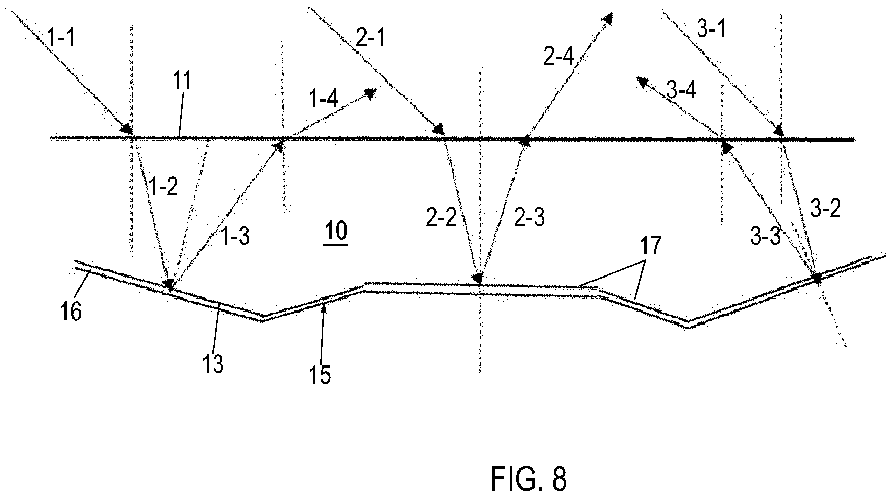

In Figur 8 sind analog zu Figur 5 beispielhaft drei verschiedene Lichtwege für die Ausgestaltung der Deckplatte von Figur 7 gezeigt. Die Reflexion der Lichtstrahlen an der Interferenzschicht 16 ist wiederum vereinfacht dargestellt. Die Ausführungen zu Figur 6 gelten analog. Aufgrund der verschieden geneigten Segmente 17 werden die Lichtstrahlen auch verschieden von der Deckplatte 10 reflektiert. Ein erster Lichtstrahl 1-1 trifft auf die Außenfläche 11 der Deckplatte 10, quert als gebrochener Lichtstrahl 1-2 die Deckplatte 10, wird als Lichtstrahl 1-3 von einem zur Ebene der Deckplatte 10 geneigten Segment 17 reflektiert, und tritt als gebrochener Lichtstrahl 1-4 von der Deckplatte 10 zur äußeren Umgebung hin aus. In entsprechender Weise trifft ein zweiter Lichtstrahl 2-1 auf die Außenfläche 11 der Deckplatte 10, quert als gebrochener Lichtstrahl 2-2 die Deckplatte 10, wird als Lichtstrahl 2-3 von einem zur Ebene der Deckplatte 10 parallelen Segment 17 reflektiert und tritt als gebrochener Lichtstrahl 2-4 von der Deckplatte 10 zur äußeren Umgebung hin aus. In entsprechender Weise trifft ein dritter Lichtstrahl 3-1 auf die Außenfläche 11 der Deckplatte 10, quert als gebrochener Lichtstrahl 3-2 die Deckplatte 10, wird als Lichtstrahl 3-3 von einem zur Ebene der Deckplatte 10 geneigten Segment 17 reflektiert, und tritt als gebrochener Lichtstrahl 3-4 von der Deckplatte 10 zur äußeren Umgebung hin aus. Lediglich für das mittlere Segment 17 ist für den einfallenden Lichtstrahl 2-1 und ausfallenden Lichtstrahl 2-4 die Bedingung Einfallswinkel = Ausfallswinkel, d.h. Reflexion im Glanzwinkel erfüllt. Die anderen Lichtstrahlen werden von den Segmenten 17 jeweils im lokalen Glanzwinkel reflektiert, welcher jedoch nicht dem Glanzwinkel der Ebene der Deckplatte 10 entspricht, so dass eine relativ starke Streuung auftritt. In Verbindung mit der optischen Interferenzschicht 16 kann eine homogene Farbwirkung für das Solarmodul 1 erzielt werden. Auch in diesem Fall kommt die Farbe für Winkel außerhalb des Glanzwinkels nur zustande, wenn das Licht mindestens einmal die Deckplatte bis zur innenliegenden Interferenzschicht passiert.

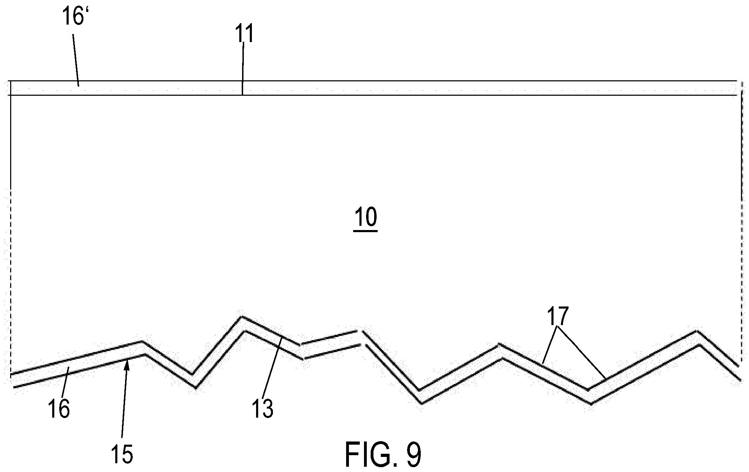

In Figur 9 ist eine weitere Ausgestaltung des erfindungsgemäßen Solarmoduls 1 veranschaulicht. Um unnötige Wiederholungen zu vermeiden, werden lediglich die Unterschiede zur Ausgestaltung von Figur 7 beschrieben und ansonsten wird auf obige Ausführungen Bezug genommen. Demnach weist das Solarmodul 1, neben der optischen Interferenzschicht 16 auf dem strukturierten Bereich 15 der Innenfläche 11 der Deckplatte 10 eine weitere optische Interferenzschicht 16' unmittelbar auf der Außenfläche 11 der Deckplatte auf. Die Außenfläche 11 ist nicht strukturiert, d.h. weist keinen strukturierten Bereich 15 analog zur Innenfläche 13 auf. Die optische Interferenzschicht 16' hat eine Schichtdicke d' und einen optischen Brechungsindex n'. Die beiden Interferenzschichten 16, 16' haben beispielsweise eine gleiche Schichtdicke (d = d') und gleichen Brechungsindex (n = n'), jedoch müssen Schichtdicke und Brechungsindex nicht notwendigerweise gleich sein. Insbesondere können Schichtdicke und Brechungsindex der beiden optischen Interferenzschichten 16 auch voneinander verschieden sein. Wenn eine gleiche optische Dicke n*d = n'*d' für die beiden optischen Interferenzschichten 16, 16' gewählt wird, kann die Farbe des Solarmoduls 1 verstärkt werden, da das den Beobachter erreichende Licht in Summe dreimal eine optische Interferenzschicht passiert und deshalb stärker gefiltert ist. Bei Beschichtung mit deutlich unterschiedlichen optischen Dicken können Mischfarben generiert werden.

Durch die Beschichtung der Außenfläche 11 der Deckplatte 10 mit einer optischen Interferenzschicht 16', bestehend aus einer anorganischen, chemisch inerten und harten Schicht wie zum Beispiel mit Si₃N₄, ergibt sich eine hohe Kratzfestigkeit, chemische Beständigkeit und schmutzabweisende Wirkung für das Solarmodul 1. Durch die Verwendung von fotokatalytischen Schichten wie TiO₂ kann sich zudem ein selbstreinigender Effekt ergeben. Eine solche obenliegende zusätzliche Schicht kann auch eine dünne Antireflexschicht mit einem Brechungsindex kleiner als jener der Deckplatte 10 sein. Dadurch wird die im Wesentlichen weiße Reflexion der Deckplatte (z.B. Glas) unterdrückt und der Sättigungsgrad der Farben steigt.

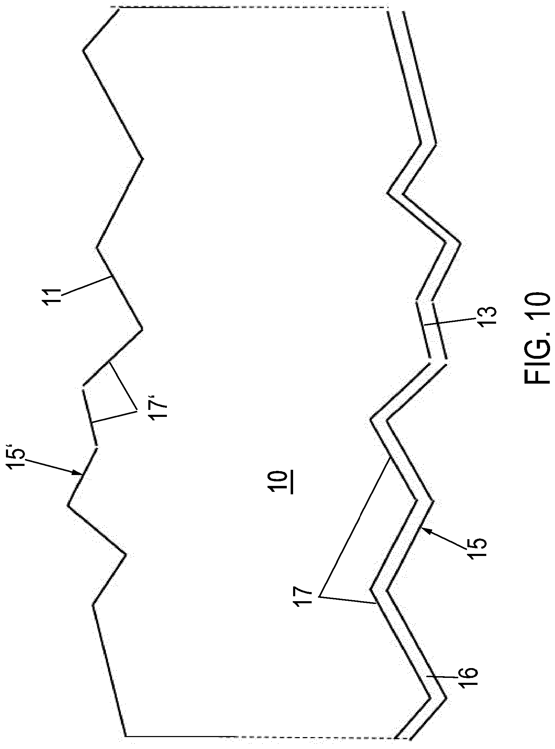

In Figur 10 ist eine weitere Ausgestaltung des erfindungsgemäßen Solarmoduls 1 veranschaulicht. Um unnötige Wiederholungen zu vermeiden, werden lediglich die Unterschiede zur Ausgestaltung von Figur 7 beschrieben und ansonsten wird auf obige Ausführungen Bezug genommen. Demnach weist die Innenfläche 13 der Deckplatte 10 des Solarmoduls 1 einen strukturierten Bereich 15 auf. Zudem weist die Außenfläche 11 der Deckplatte 10 einen weiteren strukturierten Bereich 15' mit Segmenten 17' auf. Eine optische Interferenzschicht 16 ist nur auf dem strukturierten Bereich 15 der Innenfläche 13 angeordnet. Die beiden strukturierten Bereiche 15 können gleich oder verschieden ausgebildet sein. Sowohl der strukturierte Bereich 15 der Innenfläche 13 als auch jener der Außenfläche 11 ist mit einem Höhenprofil versehen, das Berge und Täler aufweist. Hierbei bestehen mehr als 50% der der Innenfläche 13 bzw. der Außenfläche 11 aus ebenen Segmenten 17, deren Ebenen jeweils zur Ebene der Deckplatte 10 geneigt sind, d.h. einen von Null verschiedenen Winkel aufweisen. Nur für die strukturierte Innenfläche 13 gilt, dass die Segmente 17 jeweils eine Segmentfläche von mindestens 1 µm² und eine mittlere Rauigkeit von weniger als 15% der Schichtdicke d der optischen Interferenzschicht 16 haben. Für die Segmente 17' des strukturierten Bereichs 15' der Außenfläche 11 gibt es keine Bedingung für die Rauigkeit. Ein mittlerer Höhenunterschied zwischen den höchsten Punkten (Berge) und niedrigsten Punkten (Täler) der Innenfläche 13 bzw. der Außenfläche 11 beträgt mindestens 2 µm und beispielsweise maximal 20% der Dicke der transparenten Deckplatte 10. Bezogen auf die Ebene der Deckplatte 10 haben mindestens 20% der Segmente 17, 17' einen Neigungswinkel im Bereich von größer als 0° bis maximal 15°, mindestens 30% der Segmente 17, 17' einen Neigungswinkel im Bereich von größer als 15° bis maximal 45° und weniger als 30% der Segmente 17, 17' einen Neigungswinkel von größer als 45°. Im Ausführungsbeispiel von Figur 10 haben alle Segmente 17, 17' einen Neigungswinkel von maximal 45°. Auch hier muss das Licht mindestens einmal die Deckplatte bis zur innenliegenden Interferenzschicht passiert haben, um nach Reflexion und erneuter Brechung an der Außenfläche gestreut und farbgefiltert in Winkeln außerhalb des Glanzwinkels zum Beobachter zu gelangen. Durch zwei strukturierte Flächen kann die Winkelstabilität gegenüber den Ausgestaltungen in den Figuren 5, 7 und 9 nochmal erhöht werden.

In Figur 11 ist das Messverfahren zur Mehrwinkel-Farbmessung veranschaulicht, wobei die diffuse Streuung der noch nicht mit der optischen Interferenzschicht 16 beschichteten Deckplatte 10, die hier als Glasplatte ausgebildet ist, mit einem kommerziell verfügbaren Mehrwinkel-Farbmessgerät 20 (x-rite MA-T12) gemessen wird. Der strukturierte Bereich 15, 15' erstreckt sich über die komplette Außenfläche 11 der Deckplatte 10. Hierbei wird ein Lichtstrahl eines D65-Normstrahlers auf die Außenfläche 11 der zu charakterisierenden Deckplatte 10 unter verschiedenen Einfallswinkeln gerichtet und das gestreute bzw. reflektierte Licht aus verschiedenen Beobachtungswinkeln, hier beispielsweise 15° oder 45° zur Oberflächennormalen der Glasebene, spektral vermessen. Unter der Deckplatte 10 befindet sich eine schwarze, nicht glänzende Schicht 19 (z.B. angebunden mit einer Flüssigkeit mit Brechungsindex bei etwa 1.5). Mit dem Mehrwinkel-Farbmessgerät 20 kann man die Helligkeit im L-a-b System bei D65 Norm Beleuchtung und 10° Öffnungswinkel bestimmen. Es hat sich gezeigt, dass eine gute Winkelstabilität (geringe Winkelabhängigkeit des gestreuten Lichts) gegeben ist, wenn sowohl bei 45° als auch bei 15° Beobachtungswinkel und bei einem Einfallswinkel von 45°, jeweils gemessen vom Glanzwinkel (in beiden Richtungen), noch mindestens eine Helligkeit von L=10, bevorzugt L=15 und noch besser L= 20 vorliegt. Die Gradangaben sind folgendermaßen zu verstehen: Reflexionswinkel (bezogen auf Oberflächennormale / Einfallswinkel (bezogen auf Glanzwinkel). Beispielsweise fällt bei einem Beobachtungswinkel von 45° (gemessen relativ zur Oberflächennormalen) und einem Einfallswinkel von 45° (gemessen vom Glanzwinkel) der einfallende Stahl genau senkrecht zur Oberfläche ein (45/45). Bei einem Beobachtungswinkel von 15° und einem Einfallswinkel von 45° liegt die Einfallsrichtung 30° von der Oberflächennormalen auf der gleichen Seite wie die Beobachtungsrichtung (15/45). Das Mehrwinkel-Farb-Messgerät 21 ist bei einem Beobachtungswinkel von 45° bzw. 15° relativ zur Oberflächennormalen positioniert.

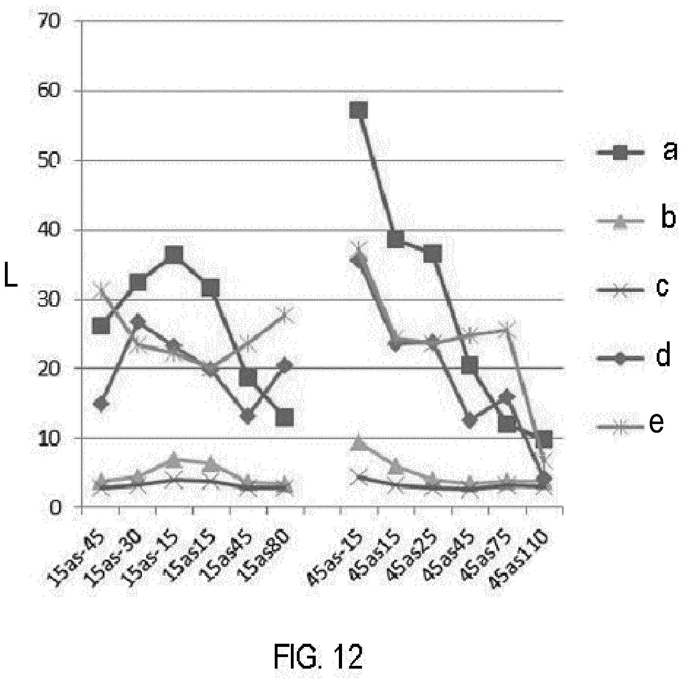

Figur 12 zeigt eine Messung der Helligkeit L verschiedener Frontgläser ohne farbgebende optische Interferenzschicht, gemessen mit einem Mehrwinkel-Farbmessgerät 20 wie in Figur 11. Auf der Rückseite der Frontgläser wurde mit Hilfe einer dünnen Schicht Glyzerin (Brechungsindex n= 1,47) ein beidseitig geschwärztes mattiertes Glas optisch angebunden, so dass im Wesentlichen die Reflexion der Oberfläche gemessen wird. Gemessen wurden ein satiniertes Glas a mit einem Haze von 94%, ein leicht texturiertes Solarglas mit Antireflexionsschicht b (Solarglas, Typ Albarino T) mit einem Haze von 2%, ein unstrukturiertes Floatglas c mit einem Haze < 0,5%, ein Walzglas d mit eingeprägter Pyramidenstruktur (parallel), sowie ein Walzglas e mit eingeprägter Pyramidenstruktur (diagonal). Die Winkelangaben entsprechen jenen von Figur 11, mit Ausnahme, dass "/" ersetzt ist durch "as".

Ersichtlich zeigen das satinierte Frontglas a und die beiden Walzgläser d, e insgesamt eine deutliche höhere Intensität des reflektierten Licht als das Solarglas b oder das Floatglas c. Das Floatglas c hat im Wesentlich nur eine Reflexion im Glanzwinkel. Insbesondere bei Winkeln weit abseits vom Glanzwinkel ist beim satinierten Glas a und den beiden Walzgläsern d, e noch eine deutliche Helligkeit zu erkennen. Genau dieser Effekt wird gemäß vorliegender Erfindung vorteilhaft in Kombination mit einer farbgebenden Interferenzschicht genutzt. Durch die Rauigkeit des Glases stehen immer mikroskopische Flächen mit verschiedenen Neigungswinkeln zur Verfügung, so dass durch die Lichtwege nach Figur 5 (strukturierte Fläche außen) oder Figur 8 (strukturierte Fläche innen) die Richtungsabhängigkeit der Farbe und vor allem der Helligkeit deutlich kleiner ist als bei Beschichtung auf einer unstrukturierten Glasscheibe mit geringem Haze (z.B. Floatglas c). Die erfindungsgemäß strukturierte Oberfläche muss in jedem Fall Facetten und Strukturgrößen in Ausdehnungen größer als die Wellenlänge des sichtbaren Lichtes aufweisen. Dazu eignen sich zum Beispiel geätzte Gläser. Die Strukturen können aber auch im Submillimeter-Bereich sein, zum Beispiel gewalzte Gläser. Es können auch gewalzte Strukturen mit geätzten Texturen kombiniert werden. Die Strukturen können auch durch Abscheideprozesse und Strukturierung eines anderen transparenten Materials auf das Glas appliziert werden. Die Strukturen sollten möglichst verschiedene Flächenneigungen mit breiten Verteilungen der Neigungswinkel haben.

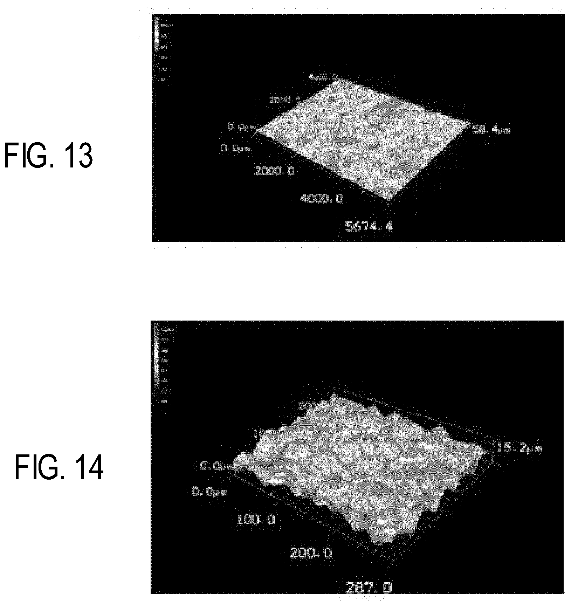

Figur 13 zeigt das Höhenprofil der leicht texturierten Glasscheibe b aus Figur 12 (Solarglas, Typ Albarino T), Figur 14 das Höhenprofil der durch Ätzung stärker strukturierten Glasscheibe a aus Figur 12 (satiniertes Glas). Die Höhenprofile wurden aus Messungen mit einem Konfokalmikroskop generiert.

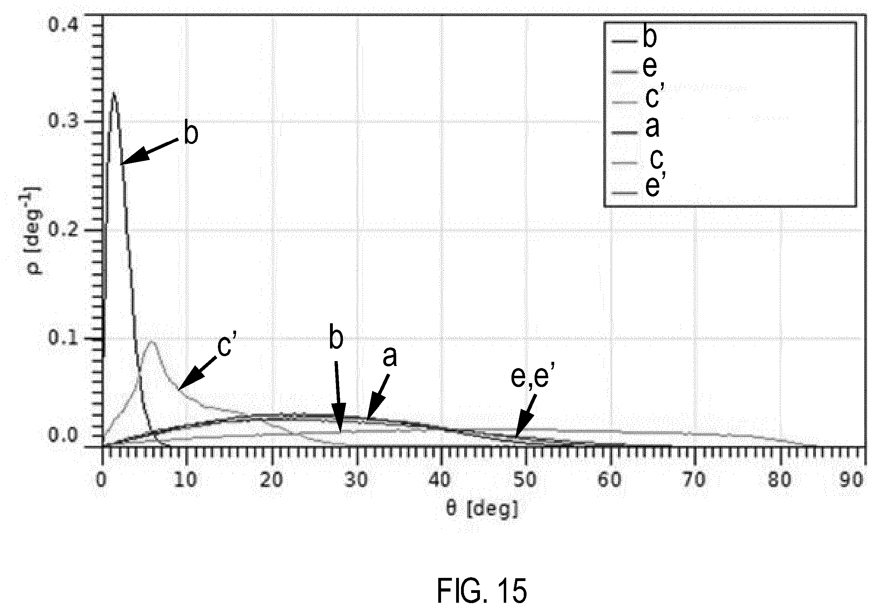

Figur 15 zeigt Winkelverteilungen, die aus den konfokalmikroskopischen Messungen von Figur 13 und 14 generiert wurden. Während bei der leicht strukturierten Glasscheibe b (Solarglas, Typ Albarino T) die Segmente sehr groß sind und Neigungswinkel von nur 5-10° auftreten, liegen die Segmente der geätzten Glasscheibe a (satiniertes Glas) im Bereich von 40 µm (Abstand Berg zu Tal in der Glasebene) mit mittleren Winkeln von ca. 25°. Die Winkelverteilung der geätzten Glasscheibe a ist sehr viel breiter als jene der leicht strukturierten Glasscheibe b. Bei der leicht texturierten Glasscheibe b findet sich bei Winkeln von größer 20-30° vom Glanzwinkel nur geringe Intensität der Reflexion (gemessen als L-Wert). Hingegen sieht man bei der satinierten Glasscheibe a noch deutliche Helligkeit bei 45/45 oder 15/45. In Figur 15 sind die Winkelverteilungen weiterer Scheiben gezeigt (satinierte Glasscheibe c, leicht texturiertes Solarglas c' vom Typ Albarino S, weitere Gläser e, e').

Erfindungsgemäß kann durch mindestens eine strukturierte Oberfläche der Deckplatte in Kombination mit einer optischen Interferenzschicht mindestens auf der Innenseite der Deckplatte eine deutlich erkennbare Verstärkung des Farbeffektes erreicht werden. Im Unterschied hierzu ist der Farbeffekt geringer und es liegt eine starke Winkelabhängigkeit vor, wenn eine optische Interferenzschicht auf die Innenfläche einer ansonsten unstrukturierten Glasscheibe aufgebracht wird. Generell führt ein höherer Brechungsindexkontrast zu einer stärkeren Reflexion und damit zu stärkeren Farben.

Aus den Gesetzmäßigkeiten für die Interferenz an dünnen Schichten ergibt sich, dass die Winkelabhängigkeit der Farbänderung bei höherem Brechungsindex kleiner ist. Die unten stehende Tabelle I zeigt die Berechnung für ein optisches Paket mit einem Eintrittsmedium mit Brechungsindex 1,5 (wie Glas), dann eine Interferenzschicht mit Brechungsindex 2,0 bzw. 2,5 und dann das Austrittsmedium mit Brechungsindex 1,5 (wie Laminierfolie). Aus Tabelle I wird deutlich, dass sich bei einer Interferenzschicht mit Brechungsindex 2.5 bei Winkeln zur Normalen bis 45° nur eine geringe Verschiebung des Reflexionsspektrums um ca. 15 nm ergibt. Bei Verwendung eines Materials mit geringerem Brechungsindex (2,0, wie etwa Si₃N₄)ist die Winkelabhängigkeit des Maximums etwas größer.

**Tabelle I**

| | | | | | | |
|---|---|---|---|---|---|---|
| Eintrittswinkel (°) | 0 | 45 | 70 | 0 | 45 | 70 |
| Brechungsindex n | 2,5 | 2,5 | 2,5 | 2 | 2 | 2 |
| Dicke (nm) | 100 | 100 | 100 | 150 | 150 | 150 |
| Wellenlänge (1. Max) | 417 | 402 | 396 | 412 | 362 | 320 |
| Blauverschiebung | - | 15 | 21 | - | 50 | 92 |

Die optische Interferenzschicht kann ein- oder mehrlagig ausgebildet sein, wobei jede Lage durch eine Brechungsschicht aus einem selben Material mit homogenem Brechungsindex gebildet wird. Insbesondere kann die optische Interferenzschicht aus genau zwei oder genau drei Brechungsschichten bestehen. Mit einer Dreifach-Schicht als Braggfilter (Lambdaviertelschichten) wird beispielsweise die Breite der farbgebenden Maxima im Reflexionsspektrum kleiner und die Intensität wird stärker. Bei geeigneter Schichtkombination kann man auch Rottöne erzeugen, die bei Einfach-Schichten kaum möglich sind, da die höheren Ordnungen immer zu viel Blau- oder Grün-Anteil einbringen. Durch zweilagige und dreilagige Schichten lässt sich der Spektralbereich des reflektierten Lichtes einengen und man hat mehr Freiheitsgrade, um den richtigen Farbton zu treffen.

Schon allein durch Verwendung von 2-lagigen optischen Interferenzschichten lassen sich also Helligkeit und Sättigung des Farbtons verbessern und gleichzeitig die Transmission optimieren. Vorzugsweise besteht die optische Interferenzschicht aus genau zwei Lagen, wobei eine erste Brechungsschicht mit einen ersten Brechungsindex n1 innen auf der Deckplatte mit Brechungsindex nd vorliegt und eine zweite Brechungsschicht mit einem zweiten Brechungsindex n2 auf der ersten Brechungsschicht vorliegt. Die zweite Brechungsschicht grenzt also an die Verkapselungsfolie. Für die Beträge der Differenzen der Brechungsindizes gilt: |n1-nd| > 0,3 und |n2-n1| > 0,3 und mindestens einer der Brechungsindizes n1 oder n2 ist größer als 1,9, bevorzugt größer als 2,3.

Die Verwendung von 3-lagigen optischen Interferenzschichten erlaubt noch mehr Farben und eine weitere Optimierung aus Farbton, Winkelabhängigkeit und Transmission. Eine optische Interferenzschicht aus genau drei Lagen (Brechungsschichten) kann aus zwei oder drei verschiedenen Materialien mit Brechungsindizes n1, n2, n3 bestehen, wobei eine erste Brechungsschicht mit einem ersten Brechungsindex n1 auf der Innenseite der Deckplatte mit Brechungsindex nd vorliegt und eine zweite Brechungsschicht mit einem zweiten Brechungsindex n2 auf der ersten Brechungsschicht vorliegt und eine dritte Brechungsschicht mit einem dritten Brechungsindex n3 auf der zweiten Brechungsschicht vorliegt. Die dritte Brechungsschicht grenzt also an die Verkapselungsfolie. Für die Beträge der Differenzen der Brechungsindizes gilt: |n3-n2| > 0,3 und |n2-n1| > 0,3 und |n1-nd| > 0,3. Dabei verhalten sich die Werte der Brechungsindizes alternierend; also entweder n1 > n2 und n3 > n2 oder n1 < n2 und n3 < n2. Zudem ist mindestens einer der Brechungsindizes n1, n2 oder n3 ist größer als 1,9, bevorzugt größer als 2,3.

Im Folgenden werden Ergebnisse der technischen Realisierung der Erfindung in verschiedenen Ausführungsformen beschrieben:
Es wurden CIGS-Dünnschichtmodule hergestellt. Anstelle eines gewöhnlichen Frontglases wurden beschichtete und strukturierte Frontgläser verwendet. Standard-Frontgläser haben eine Antireflexschicht und sind nur leicht strukturiert (Haze =2%). Als strukturierte bzw. texturierte Gläser wurden chemisch geätzte, d.h. satinierte Gläser verwendet. Die Gläser zeigten einen Haze von 94%. Mikroskop-Analysen zeigten Oberflächenstrukturen mit einer Strukturgröße von 20-40 µm und Strukturhöhen von 15 µm. Figur 14 zeigt die Konfokalmikroskop-Aufnahme der Oberfläche der verwendeten satinierten Gläser. Die Winkel der Oberflächenstrukturen (Winkel zur Glasebene) waren eher flach mit typischen Winkeln um 20-40°. Zum Vergleich wurde ein kommerziell erhältliches Frontglas mit einer Vielfachinterferenzschicht auf der Innenseite verwendet.

Die Gläser wurden auf der unstrukturierten Seite mit einer Einfachschicht von Siliziumnitrid (Si₃N₄) mittels Magnetronsputtern beschichtet. Je nach gewünschter Farbe wurden die Schichten mit Schichtdicken im Bereich 50 nm bis 250 nm abgeschieden. Dann wurden sie mit der strukturierten Seite nach außen (also der Sonne zugewandten Seite) mit dem CIGS-Dünnschicht Circuit laminiert. Als Referenz wurde ein kommerziell erhältliches Frontglas verwendet, das innen mit einer Vielfachschicht aus verschiedenen Materialien mit unterschiedlichen Brechungsindizes besteht. Anschließend wurden die Module mit einem Mehrwinkel-Farbmessgerät charakterisiert und die Farbwerte in Lhc-Koordinaten ausgewertet (L= Helligkeit, C= Chromazität oder Sättigung und H= Hue oder Farbton). Das Mehrwinkel-Farbmessgerät bietet zwei Beobachtungswinkel und jeweils 6 Beleuchtungswinkel. Die Beleuchtungswinkel werden auf den Glanzwinkel für den jeweiligen Beobachtungswinkel bezogen.

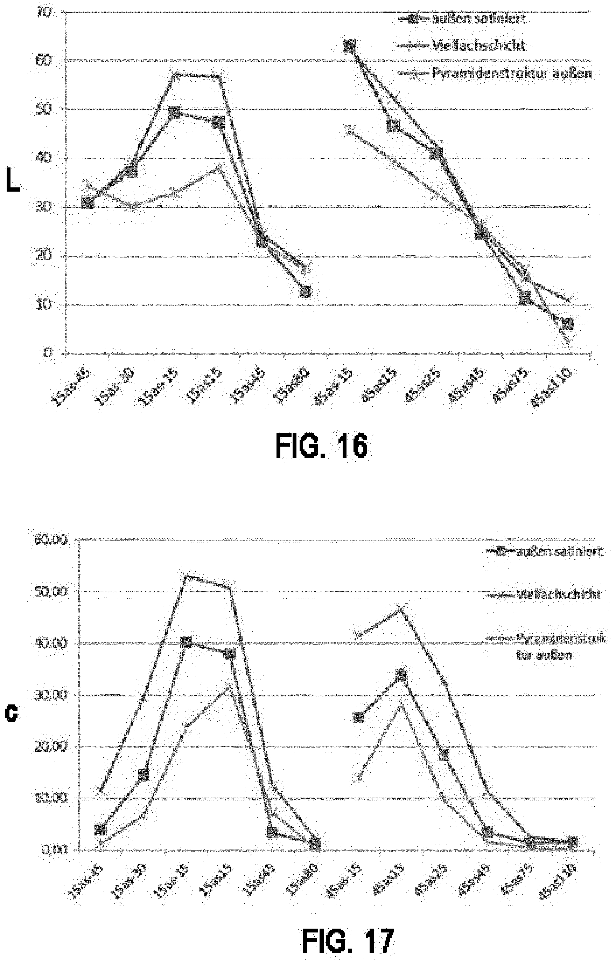

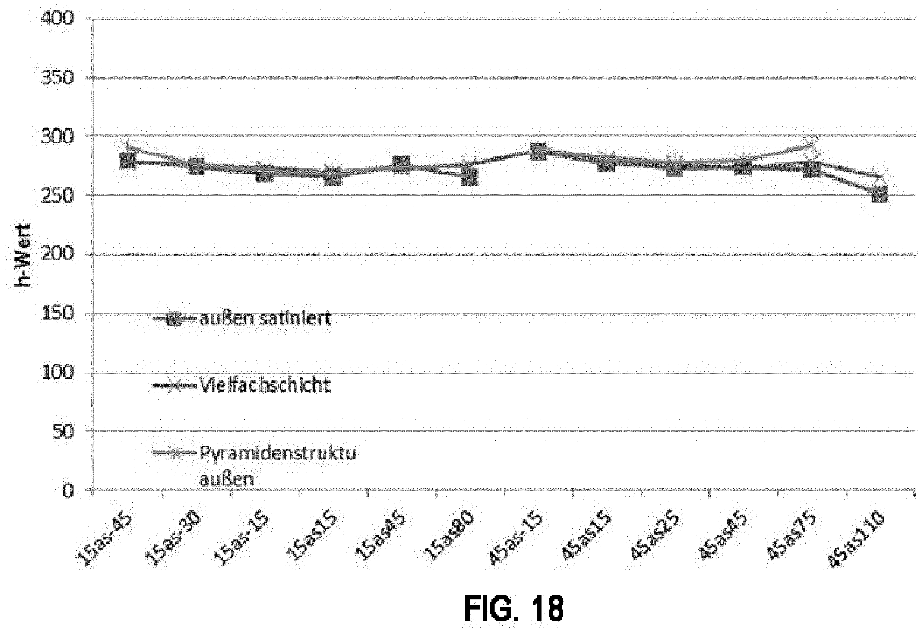

Die Figuren 16 bis 18 zeigen die Ergebnisse für L, h und c für Beschichtung innen auf der glatten Seite von Glas mit außen satinierter Seite, von Glas mit gewalzter Pyramidenstruktur außen und dem Vielfachschichtsystem (Beschichtung jeweils innen). Die Achsenbezeichnung 15as45 bedeutet dabei Detektionswinkel von 15° und Beleuchtungswinkel von 45° vom Glanzwinkel in Richtung Beobachter, d.h. der Winkel zwischen Beleuchtungs- und Beobachtungsrichtung ist kleiner als der Glanzwinkel ; 15as-45 bedeutet 45° hinter dem Glanzwinkel, d.h. der Winkel zwischen Beleuchtungs- und Beobachtungsrichtung ist größer als der Glanzwinkel.

Man erkennt, dass für die Pyramidenstruktur bei schrägem gerichtetem Einfall auch bei Winkeln außerhalb des Glanzwinkels noch deutlich Farbe zu sehen ist. Die Beschichtung auf der Innenseite mit einer einfachen Si₃N₄-Schicht kommt hinsichtlich Helligkeit und Sättigung jedoch schon nahe an die Vielfachschicht heran. Die Winkelabhängigkeit des Farbtons ist für alle Beschichtungen ähnlich.

In einem weiteren Experiment wurden Einfach-Schichten von Si₃N₄ oder Titandioxid auf verschiedene Gläser beschichtet und die Gläser wurden zu Modulen verbaut, jeweils mit der Beschichtung innen. Die Module wurden mit einem Farbmessgerät vermessen, das die Oberfläche diffus beleuchtet (Lichttyp D65) und in einem Winkel von 8° zur Oberflächennormale die Farbe misst. Dabei kann die Beleuchtung im Glanzwinkel eingeschlossen (SCI) oder ausgeschlossen (SCE) werden. Die Farbwerte wurden in CIE-Lab Koordinaten berechnet und daraus Chromazität (Sättigung) und Farbton bestimmt. Weiterhin wurde der Unterschied zwischen der Farbe bei Einschluss vom Glanzwinkel und bei Ausschluss vom Glanzwinkel in der Farbdifferenzkennziffer dE(2000) ermittelt. Auch dieses Messverfahren gibt eine erste Bewertung der Winkelstabilität.

Die folgende Tabelle II zeigt, dass schon mit einlagigen Schichten gesättigte Farben und auch helle Farbtöne erreicht werden. Die Schichtdicken lagen im Bereich von 80nm-300nm. Mit Titandioxid konnten erwartungsgemäß noch hellere und stärker gesättigte Farbtöne hergestellt werden. Mit sehr dünnen Schichten (20-40nm)lassen sich auch Grautöne erzeugen.

**Tabelle II**

| | Material | Schichtdicke | Position | L | c | h |
|---|---|---|---|---|---|---|
| blau | Si3N4 | 161 | innen | 31 | 17 | 270 |
| blau | TiO2 | 125 | innen | 33 | 34 | 277 |
| grün | Si3N4 | 211 | innen | 41 | 14 | 130 |
| gold | Si3N4 | 236 | innen | 38 | 16 | 73 |
| gold | TiO2 | 80 | innen | 45 | 46 | 90 |

Wie die Tabelle III unten zeigt, erbringt die Beschichtung auf nur leicht strukturiertem Glas nur äußerst geringe Helligkeit bei SCE Messung (ohne Glanzkomponente) und dE(2000) ist sehr groß. Bei Beschichtung von Si₃N₄ auf der glatten Innenseite von gewalztem Glas mit großer Pyramidenstruktur ist dE(2000) schon sehr gering und auch die Helligkeit der Farbe und die Sättigung sind schon deutlich höher bei Ausschluss des Glanzes. Bei Verwendung von satiniertem Glas ist die Helligkeit erhöht. dE ist leicht erhöht. Bei Beschichtung von TiO₂ auf der glatten Innenseite von satiniertem Glas erhält man einen deutlichen Anstieg von Helligkeit und vor allem Farbsättigung bei moderatem dE(2000). Wird die strukturierte Seite beschichtet und die glatte Seite nach außen gesetzt, ergibt sich ein deutlich höheres dE, jedoch haben Helligkeit und Sättigung bei Glanzausschluss immer noch deutlich höhere Werte als bei Beschichtung auf Glas mit geringerem Haze. Für starke Helligkeit und Sättigung zeigt sich also die Beschichtung einer einfachen Schicht TiO₂ auf die glatte innere Seite einer außen satinierten Scheibe sehr vorteilhaft. Die Beschichtung auf beidseitig satiniertem Glas sollte aber ebenfalls sehr vorteilhaft sein.

**Tabelle III**

| Beschreibung | Haze (nur Glas) | Beschichtung | Konfiguration | Glanz | L*(D65) | a*(D65) | b*(D65) | c | h | deltaE 2000 |
|---|---|---|---|---|---|---|---|---|---|---|
| leicht strukturiertes Glas | 2% | Si3N4 | Struktur außen, Beschichtung innen | SCI | 29,6 | -4,7 | -22,4 | 22,9 | 282 | 19,5 |
| leicht strukturiertes Glas | 2% | Si3N4 | Struktur außen, Beschichtung innen | SCE | 10,2 | 1,4 | -3,9 | 4,1 | n.A. | |
| Pyramiden Walzglas | 95% | Si3N4 | Struktur außen, Beschichtung innen | SCI | 27,2 | -0,7 | -15,8 | 15,8 | 273 | 0,8 |
| Pyramiden Walzglas | 95% | Si3N4 | Struktur außen, Beschichtung innen | SCE | 26,7 | -0,6 | -14,7 | 14,7 | 272 | |
| einseitig satiniertes Glas | 94% | Si3N4 | Struktur außen, Beschichtung innen | SCI | 31,2 | -1,7 | -17,0 | 17,1 | 276 | 2,1 |
| einseitig satiniertes Glas | 94% | Si3N4 | Struktur außen, Beschichtung innen | SCE | 29,7 | -1,2 | -14,2 | 14,3 | 275 | |
| einseitig satiniertes Glas | 94% | TiO2 | Struktur außen, Beschichtung innen | SCI | 33,1 | 3,9 | -33,5 | 33,7 | 277 | 3,2 |
| einseitig satiniertes Glas | 94% | TiO2 | Struktur außen, Beschichtung innen | SCE | 30,5 | 3,4 | -27,8 | 28,0 | 277 | |
| einseitig satiniertes Glas | 94% | TiO2 | Struktur innen, Beschichtung innen | SCI | 32,0 | 8,4 | -20,0 | 21,6 | 293 | 11,4 |
| einseitig satiniertes Glas | 94% | TiO2 | Struktur innen, Beschichtung innen | SCE | 18,2 | 16,0 | -30,4 | 34,3 | 298 | |
| Vielfachlagen | k.A. | k.A. | Beschichtung innen | SCI | 37,0 | -0,2 | -27,9 | 27,9 | 270 | 2,1 |
| Vielfachlagen | k.A. | k.A. | Beschichtung innen | SCE | 34,9 | 0,0 | -25,3 | 25,3 | 270 | |

Zum Nachweis der Optimierung von Farbe und Leistung bei gleichbleibender Winkelstabilität wurde eine dreilagige Schicht TiO₂ (27nm)/Si3N4(88nm)/TiO2(18nm) auf die glatte Innenseite eines satiniertes Deckglas mit den beschriebene Struktureigenschaften beschichtet. Im Vergleich dazu wurde eine Einfachschicht TiO₂ (125nm) auf die glatte Innenseite eines weiteren satiniertes Deckglas abgeschieden. Beide Gläser wurden mit der Beschichtung innen zu CIGS Dünnschicht Modulen weiter verarbeitet. Beide blauen Module zeigten eine vergleichbare Helligkeit (L=37)und Sättigung (c=27). Der Leistungsverlust des Modules mit der einlagigen Schicht lag bei 16%, während das Modul mit der dreilagigen Schicht nur 9% Leistung verloren hatte.

Jedoch zeigen die oben gezeigten Beispiele, dass bei Verwendung von Deckglas mit geeigneter Strukturierung und einer einlagigen Schicht schon farbige Solarmodule mit verschiedenen Farben und guter Winkelstabilität hergestellt werden können. Der moderate Leistungsverlust wird wirtschaftlich durch das vergleichsweise einfache Herstellungsverfahren mit niedrigen Kosten kompensiert.

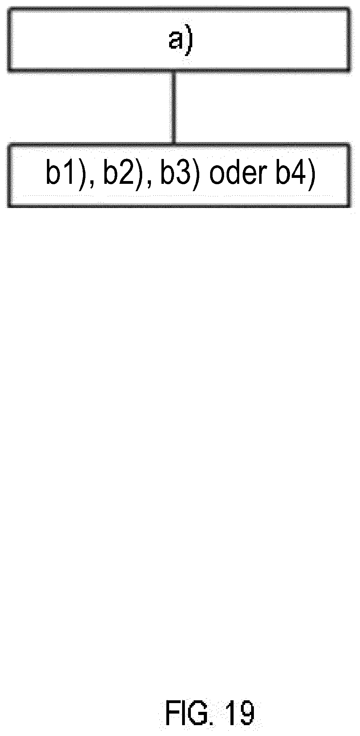

Figur 19 veranschaulicht das erfindungsgemäße Verfahren zur Herstellung des erfindungsgemäßen Solarmoduls 1.

Hierbei wird zur Bearbeitung der Deckplatte in einem ersten Verfahrensschritt a) eine ebene transparente Deckplatte bereitgestellt, die eine Außenfläche, welche der äußeren Umgebung zugewandt sein soll, und eine gegenüberliegende Innenfläche aufweist. Anschließend wird aus den folgenden vier (alternativen) Verfahrensschritten ein einziger zweiter Verfahrensschritt b1), b2), b3) oder b4) ausgewählt und durchgeführt:
b1) Strukturieren der Außenfläche mindestens in einem Bereich und Aufbringen einer optischen Interferenzschicht auf die Innenfläche. In diesem Fall wird keine weitere optische Interferenzschicht auf die Außenfläche aufgebracht. Ferner wird die Innenfläche nicht strukturiert.
b2) Strukturieren der Außenfläche mindestens in einem Bereich, Strukturieren der Innenfläche mindestens in einem Bereich und Aufbringen einer optischen Interferenzschicht auf den strukturierten Bereich der Innenfläche. In diesem Fall wird keine weitere optische Interferenzschicht auf die Außenfläche aufgebracht.
b3) Strukturieren der Innenfläche mindestens in einem Bereich und Aufbringen einer optischen Interferenzschicht auf den strukturierten Bereich der Innenfläche. In diesem Fall wird keine weitere optische Interferenzschicht auf die Außenfläche aufgebracht. Ferner wird die Außenfläche nicht strukturiert.
b4) Strukturieren der Innenfläche mindestens in einem Bereich, Aufbringen einer optischen Interferenzschicht auf den strukturierten Bereich der Innenfläche und Aufbringen einer weiteren optischen Interferenzschicht auf die Außenfläche. In diesem Fall wird die Außenfläche nicht strukturiert.

Die Erfindung stellt ein verbessertes Solarmodul sowie ein Verfahren zu dessen Herstellung zur Verfügung, das eine sehr homogene, intensive Farbe, bei geringer oder fehlender Richtungsabhängigkeit hat. Durch die Verwendung von optischer Interferenz zur Farberzeugung erhält man deutlich geringere Wirkungsgradverluste für das darunter liegende Solarmodul als bei Verwendung von opaken farbgebenden Schichten. Diese Erfindung ermöglicht ein sehr einfaches und kostengünstiges Verfahren zur Herstellung farbiger Solarmodule mit hohem Wirkungsgrad und hoher Beständigkeit.

### Bezugszeichenliste

- 1: Solarmodul
- 2: Substrat
- 3: Schichtenaufbau
- 4: Sonnenlicht
- 5: Rückelektrodenschicht
- 6: Absorberschicht
- 7: Pufferschicht
- 8: Frontelektrodenschicht
- 9: Klebeschicht
- 10: Deckplatte
- 11: Außenfläche
- 12: Solarzelle
- 13: Innenfläche
- 14: Modulrückseite
- 15, 15': strukturierter Bereich
- 16, 16': optische Interferenzschicht
- 17, 17': Segment
- 19: schwarze Schicht
- 20: Mehrwinkel-Farbmessgerät

## Patentansprüche

1. Solarmodul (1) zur fotovoltaischen Energieerzeugung, welches eine frontseitige transparente Deckplatte (10) mit einer der äußeren Umgebung zugewandten Außenfläche (11) und einer gegenüberliegenden Innenfläche (13) umfasst, wobei gemäß der Alternativen i) und ii)
i) auf der Innenfläche (13) eine optische Interferenzschicht (16) zur Reflexion von Licht innerhalb eines vorgegebenen Wellenlängenbereichs angeordnet ist, wobei die Innenfläche (13) und/oder die Außenfläche (11) jeweils mindestens einen strukturierten Bereich (15, 15') aufweist, wobei entweder die Außenfläche (11) mindestens einen strukturierten Bereich (15) aufweist oder auf der Außenfläche (11) eine weitere optische Interferenzschicht (16') zur Reflexion von Licht innerhalb eines vorgegebenen Wellenlängenbereichs angeordnet ist, oder
ii) auf der Innenfläche (13) eine optische Interferenzschicht (16) zur Reflexion von Licht innerhalb eines vorgegebenen Wellenlängenbereichs angeordnet ist, wobei die Innenfläche (13) der Deckplatte (10) mindestens einen strukturierten Bereich (15) aufweist und die Außenfläche (11) keinen strukturierten Bereich aufweist, wobei keine optische Interferenzschicht auf der Außenfläche (11) angeordnet ist,
wobei der strukturierte Bereich (15, 15') folgende Merkmale hat:
- senkrecht zur Ebene der Deckplatte (10) ein Berge und Täler aufweisendes Höhenprofil, wobei ein mittlerer Höhenunterschied zwischen den Bergen und Tälern mindestens 2 µm beträgt,
- mindestens 50% des strukturierten Bereichs (15, 15') setzt sich aus Segmenten (17, 17') zusammen, die zur Ebene der Deckplatte (10) geneigt sind, wobei, bezogen auf die Ebene der Deckplatte (10), mindestens 20% der Segmente (17, 17') einen Neigungswinkel im Bereich von größer als 0° bis maximal 15° und mindestens 30% der Segmente (17, 17') einen Neigungswinkel im Bereich von größer als 15° bis maximal 45° haben, wobei
- falls die Innenfläche (13) mindestens einen strukturierten Bereich (15') aufweist, die Segmente (17, 17') des strukturierten Bereichs (15') der Innenfläche (13) jeweils eben sind, eine Segmentfläche von mindestens 1 µm² und eine mittlere Rauigkeit von weniger als 15% einer Schichtdicke der optischen Interferenzschicht (16) auf der Innenfläche (13) haben.

2. Solarmodul (1) nach Anspruch 1, Alternative i), bei welchem die Innenfläche (13) der Deckplatte (10) keinen strukturierten Bereich aufweist und die Außenfläche (11) mindestens einen strukturierten Bereich (15) aufweist, wobei keine optische Interferenzschicht auf der Außenfläche (11) angeordnet ist.

3. Solarmodul (1) nach Anspruch 1, Alternative i), bei welchem die Innenfläche (13) der Deckplatte (10) mindestens einen strukturierten Bereich (15) aufweist und die Außenfläche (11) mindestens einen strukturierten Bereich (15') aufweist, wobei keine optische Interferenzschicht auf der Außenfläche (11) angeordnet ist.

4. Solarmodul (1) nach Anspruch 1, Alternative i), bei welchem die Innenfläche (13) der Deckplatte (10) mindestens einen strukturierten Bereich (15) aufweist und die Außenfläche (11) keinen strukturierten Bereich aufweist, wobei eine weitere optische Interferenzschicht (16') auf der Außenfläche (11) angeordnet ist.

5. Solarmodul (1) nach einem der Ansprüche 1 bis 4, bei welchem mindestens eine optische Interferenzschicht (16, 16') genau eine Brechungsschicht enthält, wobei die Brechungsschicht einen Brechungsindex n von größer als 1,7, größer als 2,0 oder größer als 2,3 hat.

6. Solarmodul (1) nach einem der Ansprüche 1 bis 5, bei welchem mindestens eine optische Interferenzschicht (16, 16') genau zwei Brechungsschichten enthält, wobei eine erste Brechungsschicht mit einem ersten Brechungsindex n1 auf der Deckplatte (10) mit einem Brechungsindex nd angeordnet ist und eine zweite Brechungsschicht mit einem zweiten Brechungsindex n2 auf der ersten Brechungsschicht angeordnet ist, wobei für die Absolutwerte der Differenzen der Brechungsindizes gilt:|n1-nd| > 0,3 und |n2-n1| > 0,3, wobei mindestens einer der Brechungsindizes n1 oder n2 größer als 1,9, bevorzugt größer als 2,3, ist.

7. Solarmodul (1) nach einem der Ansprüche 1 bis 6, bei welchem mindestens eine optische Interferenzschicht (16, 16') genau drei Brechungsschichten enthält, wobei eine erste Brechungsschicht mit einen ersten Brechungsindex n1 auf der Deckplatte (10) mit einem Brechungsindex nd angeordnet ist eine zweite Brechungsschicht mit einem zweiten Brechungsindex n2 auf der ersten Brechungsschicht angeordnet ist und eine dritte Brechungsschicht mit einem dritten Brechungsindex n3 auf der zweiten Brechungsschicht angeordnet ist, wobei für die Absolutwerte der Differenzen der Brechungsindizes gilt: |n3-n2| > 0,3, |n2-n1| > 0,3 und |n1-nd| > 0,3, wobei mindestens einer der Brechungsindizes n1, n2 oder n3 größer als 1,9, bevorzugt größer als 2,3, ist, wobei gilt:
(i) n1 > n2 und n3 > n2, oder (ii) n1 < n2 und n3 < n2.

8. Solarmodul (1) nach einem der Ansprüche 1 bis 7, bei welchem mindestens 80% eines strukturierten Bereichs (15, 15') aus zur Ebene der Deckplatte (10) geneigten Segmenten (17, 17') zusammengesetzt ist.

9. Solarmodul (1) nach einem der Ansprüche 1 bis 8, bei welchem
i) mindestens 30% der Segmente (17, 17') einen Neigungswinkel im Bereich von größer als 0° bis maximal 15°, mindestens 40% der Segmente (17, 17') einen Neigungswinkel im Bereich von größer als 15° bis maximal 45° und weniger als 10% der Segmente (17, 17') einen Neigungswinkel von größer als 45° haben, oder
ii) mindestens 40% der Segmente (17, 17') einen Neigungswinkel im Bereich von größer als 0° bis maximal 15°, mindestens 50% der Segmente (17, 17') einen Neigungswinkel im Bereich von größer als 15° bis maximal 45° und weniger als 10% der Segmente (17, 17') einen Neigungswinkel von größer als 45° haben.

10. Solarmodul (1) nach einem der Ansprüche 1 bis 9, bei welchem mindestens eine optische Interferenzschicht (16, 16') mindestens eine Verbindung, gewählt aus TiOₓ, ZrOₓ, SiC und Si₃N₄, enthält.

11. Solarmodul (1) nach einem der Ansprüche 1 bis 9, bei welchem ein mittlerer Höhenunterschied zwischen den Bergen und Tälern mindestens 50 µm oder mindestens 100 µm beträgt.

12. Solarmodul (1) nach einem der Ansprüche 1 bis 11, bei welchem die Deckplatte (10) einen Reflexions-Haze von mehr als 50%, insbesondere mehr als 90%, aufweist.

13. Solarmodul (1) nach einem der Ansprüche 1 bis 12, bei welchem die mit einer schwarzen Rückfläche versehene, wenigstens einen strukturierten Bereich (15, 15') aufweisende, unbeschichtete Deckplatte (10) so ausgebildet ist, dass bei einem Beobachtungswinkel von 45° und 15° und einem Einfallswinkel, der um 45° vom jeweiligen Glanzwinkel abweicht, eine Helligkeit L des reflektierten Lichts von mindestens 10, mindestens 15 oder mindestens 20 auftritt.

14. Verfahren zur Herstellung eines Solarmoduls (1) nach einem der Ansprüche 1 bis 13, welches die folgenden Schritte umfasst:
a) Bereitstellen einer transparenten Deckplatte (10) mit einer Außenfläche (11), welche einer äußeren Umgebung zugewandt sein soll, und einer gegenüberliegenden Innenfläche (13),
gemäß Alternative i) die folgenden Schritte b1) bis b3):
b1) Strukturieren der Außenfläche (11) mindestens in einem Bereich (15) und Aufbringen einer optischen Interferenzschicht (16) auf die Innenfläche (13), oder
b2) Strukturieren der Außenfläche (11) mindestens in einem Bereich (15), Strukturieren der Innenfläche (13) mindestens in einem Bereich (15') und Aufbringen einer optischen Interferenzschicht (16) auf den strukturierten Bereich (15') der Innenfläche (13), oder
b3) Strukturieren der Innenfläche (13) mindestens in einem Bereich (15), Aufbringen einer optischen Interferenzschicht (16) auf den strukturierten Bereich (15) der Innenfläche (13) und Aufbringen einer weiteren optischen Interferenzschicht (16') auf die Außenfläche (11),
oder gemäß Alternative ii) den folgenden Schritt:
Strukturieren der Innenfläche (13) mindestens in einem Bereich (15) und Aufbringen einer optischen Interferenzschicht (16) auf den strukturierten Bereich (15) der Innenfläche (13), wobei die Außenfläche (11) nicht strukturiert und keine optische Interferenzschicht auf der Außenfläche (11) angeordnet wird, wobei der strukturierte Bereich (15, 15') folgende Merkmale hat:
- senkrecht zur Ebene der Deckplatte (10) ein Berge und Täler aufweisendes Höhenprofil, wobei ein mittlerer Höhenunterschied zwischen den Bergen und Tälern mindestens 2 µm beträgt,
- mindestens 50% des strukturierten Bereichs (16, 16') setzt sich aus Segmenten (17, 17') zusammen, die zu einer Ebene der Deckplatte (10) geneigt sind, wobei, bezogen auf die Ebene der Deckplatte (10), mindestens 20% der Segmente (17, 17') einen Neigungswinkel im Bereich von größer als 0° bis maximal 15° und mindestens 30% der Segmente (17, 17') einen Neigungswinkel im Bereich von größer als 15° bis maximal 45° haben, wobei
- falls die Innenfläche (13) mindestens einen strukturierten Bereich (15') aufweist, die Segmente (17, 17') des strukturierten Bereichs (15') der Innenfläche (13)jeweils eben sind, eine Segmentfläche von mindestens 1 µm² und eine mittlere Rauigkeit von weniger als 15% einer Schichtdicke der optischen Interferenzschicht (16) auf der Innenfläche (13) haben.

15. Verwendung des farbigen Solarmoduls (1) nach einem der Ansprüche 1 bis 13 als integrierter Bestandteil einer Gebäudehülle oder freistehenden Wand, insbesondere als Fenster-, Fassaden- oder Dachelement.

## Claims

1. Solar module (1) for photovoltaic energy generation, which comprises a frontsided transparent cover plate (10) with an outer surface (11) facing the external environment and an opposite inner surface (13), wherein according to alternatives i) and ii)
i) an optical interference layer (16) for reflecting light within a predefined wavelength range is arranged on the inner surface (13), wherein the inner surface (13) and/or the outer surface (11) has in each case at least one patterned region (15, 15'), wherein either the outer surface (11) has at least one patterned region (15), or another optical interference layer (16') for reflecting light within a specified is arranged on the outer surface (11), or
ii) an optical interference layer (16) for reflecting light within a predefined wavelength range is arranged on the inner surface (13), wherein the inner surface (13) of the cover plate (10) has at least one patterned region (15), and the outer surface (11) has no patterned region, wherein no optical interference layer is arranged on the outer surface (11),
wherein the patterned region (15, 15') has the following features:
- perpendicular to the plane of the cover plate (10), a height profile having hills and valleys, wherein a mean height difference between the hills and valleys is at least 2 µm,
- at least 50% of the patterned region (15, 15') is composed of segments (17, 17') that are inclined relative to the plane of the cover plate (10), wherein, with reference to the plane of the cover plate (10), at least 20% of the segments (17, 17') have an inclination angle in the range from greater than 0° to a maximum of 15°, and at least 30% of the segments have an inclination angle in the range from greater than 15° to a maximum of 45°, wherein
- if the inner surface (13) has at least one patterned region (15'), the segments (17, 17') of the patterned region (15') of the inner surface (13) are in each case planar, and have a segment area of at least 1 µm² and a mean roughness of less than 15% of a layer thickness of the optical interference layer (16) on the inner surface (13).

2. Solar module (1) according to claim 1, alternative i), wherein the inner surface (13) of the cover plate (10) has no patterned region and the outer surface (11) has at least one patterned region (15), wherein no optical interference layer is arranged on the outer surface (11).

3. Solar module (1) according to claim 1, alternative i), wherein the inner surface (13) of the cover plate (10) has at least one patterned region (15), and the outer surface (11) has at least one patterned region (15'), wherein no optical interference layer is arranged on the outer surface (11).

4. Solar module (1) according to claim 1, alternative i), wherein the inner surface (13) of the cover plate (10) has at least one patterned region (15), and the outer surface (11) has no patterned region, wherein another optical interference layer (16') is arranged on the outer surface (11).

5. Solar module (1) according to one of claims 1 through 4, wherein at least one optical interference layer (16, 16') includes exactly one refraction layer, wherein the refraction layer has a refractive index n greater than 1.7, greater than 2.0, or greater than 2.3.

6. Solar module (1) according to one of claims 1 through 5, wherein at least one optical interference layer (16, 16') includes exactly two refraction layers, wherein a first refraction layer with a first refractive index n1 is arranged on the cover plate (10) with a refractive index nd, and a second refraction layer with a second refractive index n2 is arranged on the first refraction layer, wherein the following applies to the absolute values of the differences in the refractive indices: |n1-nd| > 0.3 and |n2-n1| > 0.3, wherein at least one of the refractive indices n1 or n2 is greater than 1.9, preferably greater than 2.3.

7. Solar module (1) according to one of claims 1 through 6, wherein at least one optical interference layer (16, 16') includes exactly three refraction layers, wherein a first refraction layer with a first refractive index n1 is arranged on the cover plate (10) with a refractive index nd, a second refraction layer with a second refractive index n2 is arranged on the first refraction layer, and a third refraction layer with a third refractive index n3 is arranged on the second refraction layer, wherein the following applies to the absolute values of the differences in the refractive indices: |n3-n2| > 0.3, |n2-n1| > 0.3, and |n1-nd| > 0.3, wherein at least one of the refractive indices n1, n2, or n3 is greater than 1.9, preferably greater than 2.3, wherein the following applies:
(i) n1 > n2 and n3 > n2, or (ii) n1 < n2 and n3 < n2.

8. Solar module (1) according to one of claims 1 through 7, wherein at least 80% of a patterned region (15, 15') is composed of segments (17, 17') inclined relative to the plane of the cover plate (10).

9. Solar module (1) according to one of claims 1 through 8, wherein
i) at least 30% of the segments (17, 17') have an inclination angle in the range from greater than 0° to a maximum of 15°, at least 40% of the segments (17, 17') have an inclination angle in the range from greater than 15° to a maximum of 45°, and less than 10% of the segments (17, 17') have an inclination angle greater than 45°, or
ii) at least 40% of the segments (17, 17') have an inclination angle in the range from greater than 0° to a maximum of 15°, at least 50% of the segments (17, 17') have an inclination angle in the range from greater than 15° to a maximum of 45°, and less than 10% of the segments (17, 17') have an inclination angle greater than 45°.

10. Solar module (1) according to one of claims 1 through 9, wherein at least one optical interference layer (16, 16') contains at least one compound selected from TiOₓ, ZrOₓ, SiC, and Si₃N₄.

11. Solar module (1) according to one of claims 1 through 9, wherein a mean height difference between the hills and valleys is at least 50 µm or at least 100 µm.

12. Solar module (1) according to one of claims 1 through 11, wherein the cover plate (10) has reflection haze of more than 50%, in particular more than 90%.

13. Solar module (1) according to one of claims 1 through 12, wherein the uncoated cover plate (10) having at least one patterned region (15, 15') and provided with a black back surface is implemented such that with a viewing angle of 45° and 15° and an angle of incidence that deviates by 45° from the respective glancing angle, a brightness L of the reflected light of at least 10, at least 15, or at least 20 occurs.

14. Method for producing a solar module (1) according to one of claims 1 through 13, which comprises the following steps:
a) Providing a transparent cover plate (10) with an outer surface (11), which is intended to face an external environment, and an opposite inner surface (13), according to alternative i) the following steps b1) through b3):
b1) Patterning the outer surface (11) at least in one region (15) and applying an optical interference layer (16) on the inner surface (13), or
b2) Patterning the outer surface (11) at least in one region (15), patterning the inner surface (13) at least in one region (15'), and applying an optical interference layer (16) on the patterned region (15') of the inner surface (13), or
b3) Patterning the inner surface (13) at least in one region (15), applying an optical interference layer (16) on the patterned region (15) of the inner surface (13), and applying a further optical interference layer (16') on the outer surface (11),
or according to alternative ii) the following step:
Patterning the inner surface (13) at least in one region (15) and applying an optical interference layer (16) on the patterned region (15) of the inner surface (13), wherein the outer surface (11) is not patterned and no optical interference layer is applied on the outer surface (11),
wherein the patterned region (15, 15') has the following features:
- perpendicular to the plane of the cover plate (10), a height profile having hills and valleys, wherein a mean height difference between the hills and valleys is at least 2 µm,
- at least 50% of the patterned region (15, 15') is composed of segments (17, 17') that are inclined relative to a plane of the cover plate (10), wherein, with reference to the plane of the cover plate (10), at least 20% of the segments (17, 17') have an inclination angle in the range from greater than 0° to a maximum of 15°, and at least 30% of the segments (17, 17') have an inclination angle in the range from greater than 15° to a maximum of 45°, wherein
- if the inner surface (13) has at least one patterned region (15'), the segments (17, 17') of the patterned region (15') of the inner surface (13) are planar in each case and have a segment area of at least 1 µm² and a mean roughness of less than 15% of a layer thickness of the optical interference layer (16) on the inner surface (13).

15. Use of the colored solar module (1) according to one of claims 1 through 13 as an integrated component of a building envelope or a freestanding wall, in particular as a window, façade, or roof element.

## Revendications

1. Module solaire (1) pour la production d'énergie photovoltaïque, qui comprend une plaque de couverture (10) transparente sur la face avant, avec une surface extérieure (11) tournée vers l'environnement extérieur et une surface intérieure (13) opposée, dans lequel, selon les alternatives i) et ii)
i) une couche d'interférence optique (16) destinée à réfléchir la lumière dans une plage de longueurs d'onde prédéfinie est disposée sur la surface intérieure (13), la surface intérieure (13) et/ou la surface extérieure (11) présentant chacune au moins une zone structurée (15, 15'), soit la surface extérieure (11) présentant au moins une zone structurée (15), soit une autre couche d'interférence optique (16') destinée à réfléchir la lumière dans une plage prédéfinie étant disposée sur la surface extérieure (11), ou bien
ii) une couche d'interférence optique (16) pour réfléchir la lumière à l'intérieur d'une plage de longueur d'onde prédéfinie est disposée sur la surface intérieure (13), dans laquelle la surface intérieure (13) de la plaque de couverture (10) a au moins une zone structurée (15), et la surface extérieure (11) n'a pas de zone structurée, dans laquelle aucune couche d'interférence optique n'est disposée sur la surface extérieure (11),
dans lequel la zone structurée (15, 15') présente les caractéristiques suivantes :
- perpendiculairement au plan de la plaque de recouvrement (10), un profil de hauteur ayant des collines et des vallées, dans lequel une différence de hauteur moyenne entre les collines et les vallées est d'au moins 2 µm,
- au moins 50 % de la zone structurée (15, 15') est composée de segments (17, 17') qui sont inclinés par rapport au plan de la plaque de recouvrement (10), dans laquelle, par rapport au plan de la plaque de recouvrement (10), au moins 20 % des segments (17, 17') ont un angle d'inclinaison dans la plage allant de plus de 0° à un maximum de 15°, et au moins 30 % des segments ont un angle d'inclinaison dans la plage allant de plus de 15° à un maximum de 45°, dans laquelle
- si la surface intérieure (13) présente au moins une zone structurée (15'), les segments (17, 17') de la zone structurée (15') de la surface intérieure (13) sont respectivement plans et présentent une surface de segment d'au moins 1 µm² et une rugosité moyenne inférieure à 15% d'une épaisseur de couche de la couche d'interférence optique (16) sur la surface intérieure (13).

2. Module solaire (1) selon la revendication 1, alternative i), dans lequel la surface intérieure (13) de la plaque de couverture (10) ne présente pas de zone structurée et la surface extérieure (11) présente au moins une zone structurée (15), aucune couche d'interférence optique n'étant disposée sur la surface extérieure (11).

3. Module solaire (1) selon la revendication 1, alternative i), dans lequel la surface intérieure (13) de la plaque de couverture (10) a au moins une zone structurée (15), et la surface extérieure (11) a au moins une zone structurée (15'), dans lequel aucune couche d'interférence optique n'est disposée sur la surface extérieure (11).

4. Module solaire (1) selon la revendication 1, alternative i), dans lequel la surface intérieure (13) de la plaque de couverture (10) a au moins une zone structurée (15), et la surface extérieure (11) n'a pas de zone structurée, dans lequel une autre couche d'interférence optique (16') est disposée sur la surface extérieure (11).

5. Module solaire (1) selon l'une des revendications 1 à 4, dans lequel au moins une couche d'interférence optique (16, 16') comprend exactement une couche de réfraction, dans lequel la couche de réfraction a un indice de réfraction n supérieur à 1,7, supérieur à 2,0, ou supérieur à 2,3.

6. Module solaire (1) selon l'une des revendications 1 à 5, dans lequel au moins une couche d'interférence optique (16, 16') comprend exactement deux couches de réfraction, dans lequel une première couche de réfraction avec un premier indice de réfraction n1 est disposée sur la plaque de couverture (10) avec un indice de réfraction nd, et une deuxième couche de réfraction avec un deuxième indice de réfraction n2 est disposée sur la première couche de réfraction, dans lequel ce qui suit s'applique aux valeurs absolues des différences des indices de réfraction : |n1-nd| > 0,3 et |n2-n1| > 0,3, où au moins un des indices de réfraction n1 ou n2 est supérieur à 1,9, de préférence supérieur à 2,3.

7. Module solaire (1) selon l'une des revendications 1 à 6, dans lequel au moins une couche d'interférence optique (16, 16') comprend exactement trois couches de réfraction, dans lequel une première couche de réfraction avec un premier indice de réfraction n1 est disposée sur la plaque de couverture (10) avec un indice de réfraction nd, une deuxième couche de réfraction avec un deuxième indice de réfraction n2 est disposée sur la première couche de réfraction, et une troisième couche de réfraction avec un troisième indice de réfraction n3 est disposée sur la deuxième couche de réfraction, dans laquelle ce qui suit s'applique aux valeurs absolues des différences dans les indices de réfraction : |n3-n2| > 0,3, |n2-n1| > 0,3, et |n1-nd| > 0,3, dans lequel au moins un des indices de réfraction n1, n2 ou n3 est supérieur à 1,9, de préférence supérieur à 2,3, dans lequel ce qui suit s'applique :
(i) n1 > n2 et n3 > n2, ou (ii) n1 < n2 et n3 < n2.

8. Module solaire (1) selon l'une des revendications 1 à 7, dans lequel au moins 80% d'une zone structurée (15, 15') est composée de segments (17, 17') inclinés par rapport au plan de la plaque de couverture (10).

9. Module solaire (1) selon l'une des revendications 1 à 8, dans lequel
i) au moins 30% des segments (17, 17') ont un angle d'inclinaison compris entre plus de 0° et un maximum de 15°, au moins 40% des segments (17, 17') ont un angle d'inclinaison compris entre plus de 15° et un maximum de 45°, et moins de 10% des segments (17, 17') ont un angle d'inclinaison supérieur à 45°, ou
ii) au moins 40% des segments (17, 17') ont un angle d'inclinaison compris entre plus de 0° et un maximum de 15°, au moins 50% des segments (17, 17') ont un angle d'inclinaison compris entre plus de 15° et un maximum de 45°, et moins de 10% des segments (17, 17') ont un angle d'inclinaison supérieur à 45°.

10. Module solaire (1) selon l'une des revendications 1 à 9, dans lequel au moins une couche d'interférence optique (16, 16') contient au moins un composé choisi parmi TiOₓ, ZrOₓ, SiC, et Si₃N₄.

11. Module solaire (1) selon l'une des revendications 1 à 9, dans lequel une différence de hauteur moyenne entre les collines et les vallées est d'au moins 50 µm ou d'au moins 100 µm.

12. Module solaire (1) selon l'une des revendications 1 à 11, dans lequel la plaque de couverture (10) présente un trouble de réflexion supérieur à 50%, notamment supérieur à 90%.

13. Module solaire (1) selon l'une des revendications 1 à 12, dans lequel la plaque de recouvrement (10) non revêtue présentant au moins une zone structurée (15, 15') et pourvue d'une surface arrière noire est réalisée de telle sorte que, pour un angle d'observation de 45° et 15° et un angle d'incidence qui s'écarte de 45° de l'angle d'incidence respectif, on obtient une luminosité L de la lumière réfléchie d'au moins 10, au moins 15 ou au moins 20.

14. Procédé de fabrication d'un module solaire (1) selon l'une des revendications 1 à 13, qui comprend les étapes suivantes :
a) Fournir une plaque de couverture transparente (10) avec une surface extérieure (11), qui est destinée à faire face à un environnement extérieur, et une surface intérieure opposée (13),
selon la variante i), les étapes suivantes b1) à b3) :
b1) structurer la surface extérieure (11) au moins dans une zone (15) et appliquer une couche d'interférence optique (16) sur la surface intérieure (13), ou
b2) structurer la surface extérieure (11) au moins dans une zone (15), structurer la surface intérieure (13) au moins dans une zone (15'), et appliquer une couche d'interférence optique (16) sur la zone structurée (15') de la surface intérieure (13), ou
b3) structurer la surface intérieure (13) au moins dans une zone (15), appliquer une couche d'interférence optique (16) sur la zone structurée (15) de la surface intérieure (13), et appliquer une autre couche d'interférence optique (16') sur la surface extérieure (11),
ou selon l'alternative ii) l'étape suivante :
structurer la surface intérieure (13) au moins dans une zone (15) et appliquer une couche d'interférence optique (16) sur la zone structurée (15) de la surface intérieure (13), dans laquelle la surface extérieure (11) n'est pas structurée et aucune couche d'interférence optique n'est appliquée sur la surface extérieure (11),
dans lequel la zone structurée (15, 15') présente les caractéristiques suivantes :
- perpendiculairement au plan de la plaque de recouvrement (10), un profil de hauteur ayant des collines et des vallées, dans lequel une différence de hauteur moyenne entre les collines et les vallées est d'au moins 2 µm,
- au moins 50 % de la région à motifs (15, 15') est composée de segments (17, 17') qui sont inclinés par rapport à un plan de la plaque de recouvrement (10), dans lequel, par rapport au plan de la plaque de recouvrement (10), au moins 20 % des segments (17, 17') ont un angle d'inclinaison dans la plage allant de plus de 0° à un maximum de 15°, et au moins 30 % des segments (17, 17') ont un angle d'inclinaison dans la plage allant de plus de 15° à un maximum de 45°, dans lequel
- si la surface intérieure (13) présente au moins une zone structurée (15'), les segments (17, 17') de la zone structurée (15') de la surface intérieure (13) sont respectivement plans et présentent une surface de segment d'au moins 1 µm² et une rugosité moyenne inférieure à 15% d'une épaisseur de couche de la couche d'interférence optique (16) sur la surface intérieure (13).

15. Utilisation du module solaire coloré (1) selon l'une des revendications 1 à 13 comme composant intégré d'une enveloppe de bâtiment ou d'un mur autoportant, en particulier comme élément de fenêtre, de façade ou de toit.
